# EUROPEAN PATENT SPECIFICATION

(11) **EP 2 084 171 B1**
(45) Date of publication and mention of the grant of the patent: **10.04.2013**
(21) Application number: 07831590.0
(22) Date of filing: 05.11.2007
(51) Int. Cl.: C07F 15/00, H05B 33/22

(54) **IRIDIUM COMPLEX COMPOUND, ORGANIC ELECTROLUMINESCENT DEVICE OBTAINED BY USING THE SAME, AND USES OF THE DEVICE**
IRIDIUMKOMPLEXVERBINDUNGEN, UNTER DEREN VERWENDUNG ERHALTENES ORGANISCHES ELEKTROLUMINESZIERENDES GERÄT UND ANWENDUNGEN DES GERÄTES
COMPOSÉ COMPLEXE DE L'IRIDIUM, DISPOSITIF ÉLECTROLUMINESCENT ORGANIQUE OBTENU PAR UTILISATION DE CELUI-CI, ET UTILISATION DU DISPOSITIF

(30) Priority: 07.11.2006 JP 2006301981
(43) Date of publication of application: 05.08.2009
(73) Proprietor: Showa Denko K.K., Tokyo 105-8518 (JP)
(72) Inventor: IGARASHI, Takeshi, Chiba-shi Chiba 2670056 (JP)
(74) Representative: Strehl Schübel-Hopf & Partner
(86) International application number: PCT/JP2007/071859
(87) International publication number: WO 2008/056799

(56) References cited:
- EP-A- 1 549 112
- WO-A-2004/020547
- LASKAR, INAMUR R. ET AL: "Investigating photoluminescence and electroluminescence of iridium(III)-based blue-emitting phosphors" POLYHEDRON , 25(5), 1167-1176 CODEN: PLYHDE; ISSN: 0277-5387, 2006, XP002466160

## Description

### BACKGROUND OF THE INVENTION

The present invention relates to an iridium complex compound, and more specifically to an iridium complex compound having phosphorescence, an organic electroluminescent device obtained by using the same and uses thereof.

### RELATED ART

In recent years, materials are actively developed by using phosphorescent compounds having a high luminous efficiency in order to expand uses of organic electroluminescent devices (in the present specification, also referred to as organic EL devices).

In order to expand uses of organic EL devices to the field of displays, it is essential to develop materials enabling stable driving of the device as well as having a high luminous efficiency.
It is disclosed in Japanese Patent Application Laid-Open (through PCT) No. 526876/2003 (patent document 1) that use of an organic iridium complex compound as a phosphorescent compound makes it possible to enhance a luminous efficiency of an organic EL device to a large extent. Tris(2-(2-pyridyl)phenyl)iridium and derivatives thereof are shown as examples of the iridium complex compound, and it is described that a luminescent color of an iridium complex compound is changed by altering a substituent of the aromatic ligand to an alkyl group or an aryl group.

Further, various groups are disclosed in Japanese Patent Application Laid-Open No. 247859/2001 (patent document 2) as examples of the substituents for tris(2-(2-pyridyl)phenyl)iridium.
On the other hand, a vacuum vapor deposition method of low molecular weight organic compounds and a coating method of polymer compound solutions are usually used for forming a luminescent layer in an organic EL device. The coating method is advantageous in terms of low production cost of the device and easy production of large-area device, and techniques for producing devices by the coating method are desired to be improved in the future. However, conventional iridium complex compounds usually have inferior solubility, and crystallization is brought about in a certain case by aggregation and association in forming a film by coating. Further, there has been a problem that if a film in which crystals are aggregated or associated is used for a luminescent layer of an organic EL device, not only emission is uneven but also a life of the device is shortened.

Further, a synthetic process of iridium complex compounds in which two kinds of bidentate ligands are coordinated is described in Polyhedron 25, 1167 (2006) (non-patent document 1). Such iridium complex compounds are excellent in solubility, but in general, there has been a problem that when the iridium complex compounds having two phenylpyridine ligands and one bidentate ligand other than phenylpyridine are used for an organic EL device, the life of the device is short.
Patent document 1: Japanese Patent Application Laid-Open (through PCT) No. 526876/2003
Patent document 2: Japanese Patent Application Laid-Open No. 247859/2001
Non-patent document 1: Polyhedron 25, 1167 (2006)
WO 2004/020547 A discloses Iridium-complex compounds Ir(Fppy)₃ substituted with a hydrocarbon group which is linked via a -CH₂- group to the phenyl ring. EP 1549112 A1 discloses iridium complexes for organic electroluminescence devices with N-containing condensed aromatic rings.

### DISCLOSURE OF THE INVENTION

In organic EL devices prepared by using the iridium complex compounds described in the patent documents 1 and 2, the lives (reduction in luminance observed when applying a constant electric current to the devices) and the luminescent efficiencies of the devices prepared by coating a solution containing a polymer compound and the iridium complex compound have not been satisfactory.

This is considered to be brought about by the following causes: that is, the solubilities of the iridium complex compounds are never investigated in the patent documents 1 and 2, and iridium complex compounds which have so far been known have poor solubilities; and when coating a solution containing a polymer compound and an iridium complex compound, the iridium complex compound is aggregated, so that the film-forming property is not excellent.

The iridium complex compound described in the non-patent document 1 is excellent in solubility, but even when the above iridium complex compound is used to prepare an organic EL device, a life of the device has not been satisfactory since the iridium complex compound is inferior in stability.

The present invention has been made in light of the above problems, and an object of the present invention is to provide an organic EL device having a high luminous efficiency and a long life and an iridium complex compound having excellent solubility which is used for the above device.

Intensive researches by the present inventors in order to achieve the object described above have resulted in the finding that an organic EL device comprising a luminescent layer containing an iridium complex compound which has excellent solubility and which possesses a specific structure has a low barrier for charge injection from an electrode and is extended in life, and thus the present inventors have come to complete the present invention.

That is, the present invention relates to the subject-matter defined in the claims.

The iridium complex compound according to the present invention has excellent solubility, and the organic EL device prepared by using the complex compound has a high luminous efficiency and is extended in life.

### BRIEF DESCRIPTION OF THE DRAWINGS

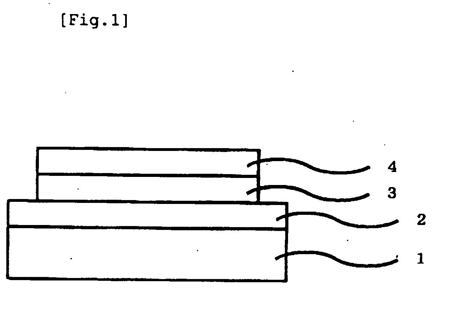

Fig. 1 is a cross-sectional view showing an example of the organic EL device according to the present invention.

### EXPLANATION OF THE SIGNS

1: Glass substrate
2: Anode
3: Luminescent layer
4: Cathode

### BEST MODE FOR CARRYING OUT THE INVENTION

The present invention shall specifically be explained below.

### Iridium complex compound:

The iridium complex compound of the present invention is represented by the following Formula (1):

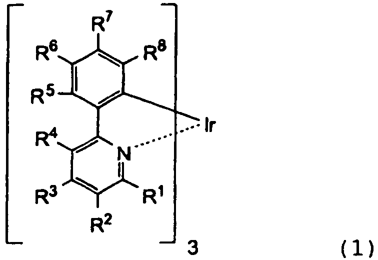

wherein in Formula (1), R¹ to R⁴ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms, a halogen atom or a cyano group, and wherein R¹ to R⁴ are defined such that one of R¹ to R⁴ is a group having 2 or more carbon atoms, and the group having 2 or more carbon atoms is a group represented by the following Formula (2): 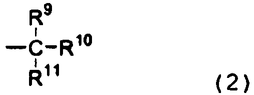 wherein in Formula (2), at least two of R⁹ to R¹¹ are hydrocarbon groups having one or more carbon atoms, and when two of R⁹ to R¹¹ are the hydrocarbon groups having one or more carbon atoms, the other is a hydrogen atom, or that two or more of R¹ to R⁴ are groups having 2 or more carbon atoms;
R⁵ to R⁸ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms or a specific electron-withdrawing group;
at least one of R⁵ to R⁸ is the specific electron-withdrawing group; with the proviso that R¹ to R⁸ are not combined with each other to form rings; and the specific electron-withdrawing group is selected from the group consisting of a halogen atom, an alkyl group having 1 to 10 carbon atoms which is substituted with fluorine, an alkoxy group having 1 to 10 carbon atoms which is substituted with fluorine, a cyano group, an aldehyde group, an acyl group having 2 to 10 carbon atoms, an alkoxycarbonyl group having 2 to 10 carbon atoms, a group represented by the following Formula (I), a thiocyanate group and a group represented by the following Formula (II)];

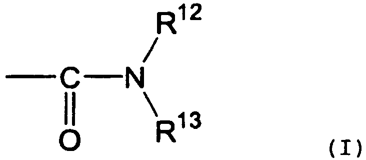

wherein in Formula (I), R¹² and R¹³ are each independently a hydrogen atom or a hydrocarbon group having 1 to 9 carbon atoms, and when R¹² and R¹³ are the hydrocarbon groups, the total of the carbon atoms thereof is 9 or less;

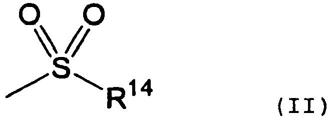

wherein in Formula (II), R¹⁴ is a hydrocarbon group having 1 to 10 carbon atoms.
The iridium complex compound represented by Formula (1) described above has phosphorescence and is excellent in solubility, and therefore an organic EL device in which the above compound is contained in a luminescent layer can suitably be produced by a coating method.

In the present invention, the iridium complex compounds described above may be used singly or in combination of two or more kinds.

When two or more of R¹ to R⁴ are groups having 2 or more carbon atoms, the group having 2 or more carbon atoms is preferably a bulky group. Such bulky group having 2 or more carbon atoms sterically isolates an excited state of the reactive iridium complex compound of the present invention from other molecules contained in the luminescent layer and therefore is advantageous for extending the life of the organic EL device.

When the group having 2 or more carbon atoms is the group represented by Formula (2), a peak emission wavelength of the iridium complex compound is shifted to a shorter wavelength side, and the value of the compound as a blue light emitting material tends to be enhanced.

In Formula (2), more preferably, R⁹ to R¹¹ are each independently an alkyl group.
When R⁹ to R¹¹ are each independently an alkyl group, the group represented by Formula (2) is sufficiently bulky. Such bulky group sterically isolates an excited state of the reactive iridium complex compound of the present invention from other molecules contained in the luminescent layer and therefore is particularly advantageous for extending the life of the organic EL device.

In Formula (1) described above, R³ is preferably the group represented by Formula (2). If R³ is the group represented by Formula (2), a peak emission wavelength of the iridium complex compound is scarcely changed or is shifted to a shorter wavelength side only by several nm as compared with a complex compound which is not substituted. However, when R² or R⁴ is the group having 2 or more carbon atoms, the peak emission wavelength tends to be shifted to a longer wavelength side as compared with a complex compound which is not substituted, and the value of the compound as a blue light emitting material is a little inferior. Further, when R¹ is the group having 2 or more carbon atoms, the improvement of solubility is somewhat small due to a steric structural factor.

The group having 2 or more carbon atoms described above is preferably a hydrocarbon group having a branched structure. Examples thereof include isobutyl, 2-methylbutyl, 2-ethylhexyl, isopropyl, sec-butyl, 1-ethylpropyl, 1-butylpentyl, 1-phenylethyl, tertiary butyl, 1,1-dimethylethyl, 1,1-dimethylpropyl, 1,1-diethylpropyl, 1,1-dimethylbutyl, 1,1-diethylbutyl, 1,1-dipropylbutyl, 1,1-dimethylpentyl, 1,1-diethylpentyl, 1,1-dipropylpentyl, 1,1-dibutylpentyl, 1,1-dimethylhexyl, 1,1-diethylhexyl, 1,1-dipropylhexyl, 1,1-dibutylhexyl, 1,1-dipentylhexyl and the like. Tertiary butyl, 1,1-dimethylethyl, 1,1-dimethylpropyl, 1,1-dimethylbutyl, 1,1-dimethylpentyl and 1,1-dimethylhexyl are preferred, and tertiary butyl is most preferred.

When the compound represented by Formula (1) described above has two or more groups having 2 or more carbon atoms described above, at least R² and R³ are preferably the groups having 2 or more carbon atoms. When R⁴ is the group having 2 or more carbon atoms, the peak emission wavelength tends to be shifted to a longer wavelength side as compared with a complex compound which is not substituted, and the value of the compound as a blue light emitting material is a little inferior. Further, when R¹ is the group having 2 or more carbon atoms, the improvement of solubility is somewhat small due to a steric structural factor.

The iridium complex compound of the present invention is preferably represented by the following Formula (3):

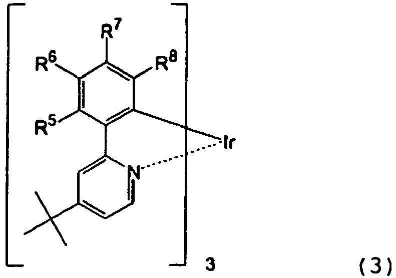

wherein in Formula (3), R⁵ to R⁸ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms or a specific electron-withdrawing group; at least one of R⁵ to R⁸ is the specific electron-withdrawing group; with the proviso that R⁵ to R⁸ are not combined with each other to form rings; and the specific electron-withdrawing group is selected from the group consisting of a halogen atom, an alkyl group having 1 to 10 carbon atoms which is substituted with fluorine, an alkoxy group having 1 to 10 carbon atoms which is substituted with fluorine, a cyano group, an aldehyde group, an acyl group having 2 to 10 carbon atoms, an alkoxycarbonyl group having 2 to 10 carbon atoms, a group represented by the following Formula (I), a thiocyanate group and a group represented by the following Formula (II) ;

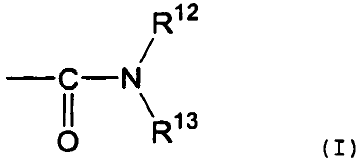

wherein in Formula (I), R¹² and R¹³ are each independently a hydrogen atom or a hydrocarbon group having 1 to 9 carbon atoms, and when R¹² and R¹³ are the hydrocarbon groups, the total of the carbon atoms thereof is 9 or less;

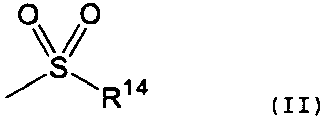

wherein in Formula (II), R¹⁴ is a hydrocarbon group having 1 to 10 carbon atoms.
The iridium complex compound represented by Formula (3) described above has a tertiary butyl group and therefore is excellent in solubility. Since the tertiary butyl group is a bulky group, the tertiary butyl group sterically isolates an excited state of the reactive iridium complex compound of the present invention from other molecules contained in the luminescent layer and therefore is advantageous for extending the life of the organic EL device.

In the iridium complex compound of the present invention, examples of the electron-withdrawing groups described above include substituents in which the standard substituent constant (σ·ₚ) is positive among substituents described in Table 11·9 at pages II-347 and II-348 in KAGAKU BINRAN KISOHEN II (Chemical Manual Basic Edition II) revised 4th edition, edited by The Chemical Society of Japan. Preferred examples include halogen atoms (preferably a fluorine atom), alkyl groups having 1 to 10 carbon atoms which are substituted with fluorine, alkoxy groups having 1 to 10 carbon atoms which are substituted with fluorine and a cyano group. Among them, a fluorine atom is preferable from the viewpoint of the luminescence characteristics such as the emission wavelength and the emission quantum efficiency.

Preferably, two or more of R⁵ to R⁸ are the electron-withdrawing groups. Particularly preferably, two of R⁵ to R⁸ are the electron-withdrawing groups from the viewpoints of the luminescence characteristics such as the emission wavelength and the emission quantum efficiency and easiness in the production.

The iridium complex compound of the present invention is preferably represented by the following Formula (4):

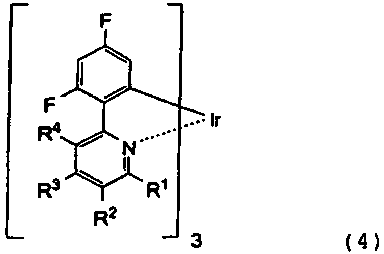

wherein in Formula (4), R¹ to R⁴ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms, a halogen atom or a cyano group; and one of R¹ to R⁴ is a group having 2 or more carbon atoms;
with the proviso that R¹ to R⁴ are not combined with each other to form rings.
The iridium complex compound represented by Formula (4) described above not only is excellent in solubility but also has a blue light emitting property.

Among the iridium complex compounds of the present invention, the iridium complex compounds represented by the following Formula (5) have a blue light emitting property and solubility in combination and have a bulky group:

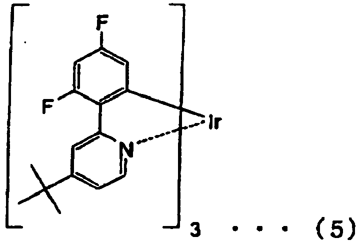

The iridium complex compound represented by Formula (5) described above has a bulky tertiary butyl group. The bulky tertiary butyl group sterically isolates an excited state of the reactive iridium complex compound of the present invention from other molecules contained in the luminescent layer and therefore is advantageous for extending the life of the organic EL device.

The iridium complex compound of the present invention is preferably a facial complex.
Iridium complexes have structural isomers as described at page 156 of "Basic Inorganic Chemistry" cowritten by Cotton, Wilkinson and Gauss. In particular, tris complexes represented by tris(2-phenylpyridine)iridium have a facial coordination or a meridional coordination. Facial complexes and meridional complexes can be selectively produced by processes described in, for example, J. Am. Chem. Soc., vol. 125, No. 24, pp. 7377 to 7387 (2003). If they are obtained in the form of a mixture, they can be separated by column chromatography and be identified by ¹H-NMR or ¹³C-NMR.

The iridium complex compound of the present invention may be a mixture of a facial complex and a meridional complex. The facial complex preferably accounts for not less than 50%, more preferably not less than 95%, particularly preferably 100% of the iridium complex compound. The facial complex is preferred since it has a higher quantum efficiency of emission as compared with that of the meridional complex.

In the present specification, the meridional complex and the facial complex are also referred to as mer complex and fac complex, respectively.
The iridium complex compound of the present invention is excellent in solubility and therefore can be particularly preferably used in producing an organic EL device by a coating method. In a film obtained by the coating method using the iridium complex compound of the present invention, the iridium complex compound does not crystallize by aggregation and association, and therefore an obtainable organic EL device emits light evenly and is excellent in luminous efficiency and durability.

Specific examples of the iridium complex compounds of the present invention shall be given below, but the present invention shall not be restricted to them.

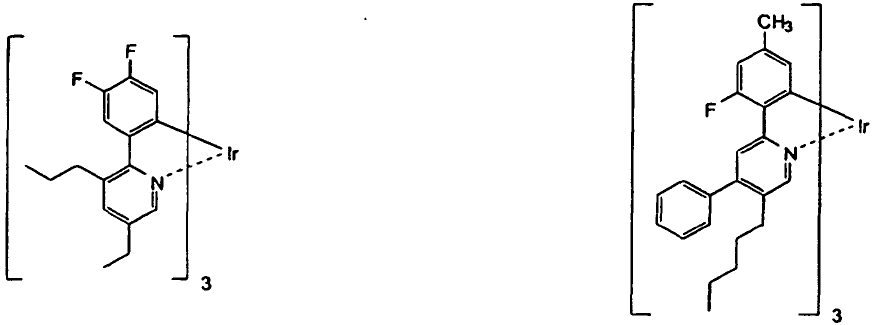

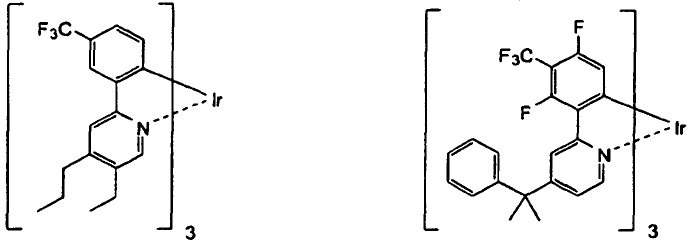

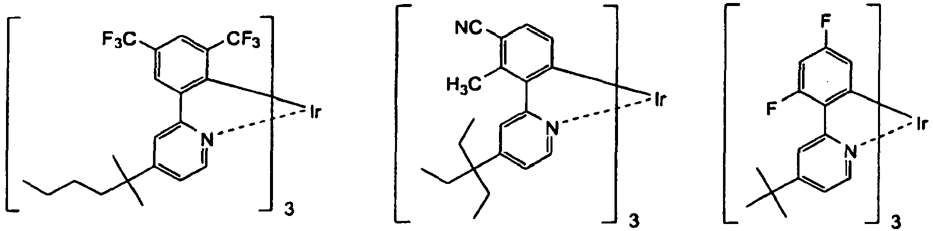

### Production process for iridium complex compound:

Production processes for the iridium complex compounds of the present invention are not particularly limited. For example, the iridium complex compounds may be produced by the following process.

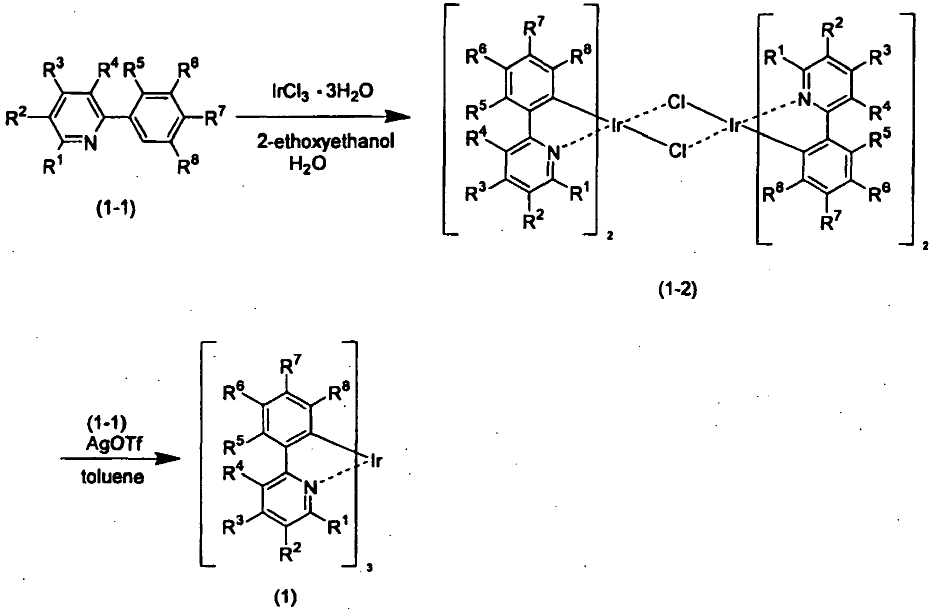

One exemplary production process for the iridium complex compound of the present invention shall be explained with reference to the scheme shown above.
First, iridium (III) chloride trihydrate is reacted with a phenylpyridine derivative (1-1) in a 2-ethoxyethanol/water mixed solvent (2-ethoxyethanol : water = 3 : 1 (volume ratio)) by heating under reflux, whereby a binuclear iridium complex (1-2) is obtained.

R¹ to R⁸ in the formulas (1-1) and (1-2) each have the same meanings as those of R¹ to R⁸ in Formula (1).
Next, the above binuclear complex (1-2) is reacted with the phenylpyridine derivative (1-1) in a solvent such as toluene in the presence of a silver salt such as silver (I) trifluoromethanesulfonate by heating under reflux, whereby an iridium complex compound (1) of the present invention can be obtained. In this case, if an inorganic basic compound such as sodium carbonate or potassium carbonate, or an organic base such as tributylamine or lutidine is added, the objective iridium complex compound (1) of the present invention tends to be obtained at a high yield. When toluene is used as the solvent, the iridium complex compound tends to be obtained in the form of a mixture of a facial complex and a meridional complex. When mesitylene or the like having a higher boiling point is used as the solvent to carry out the heating under reflux, the iridium complex compound having a facial coordination tends to be obtained at a high yield and with high selectivity.

### Organic EL device:

The organic EL device according to the invention is prepared by using the above-described iridium complex compound. The organic EL device may comprise a substrate, a pair of electrodes formed on the substrate, and one or plural organic layers including a luminescent layer which are formed between the pair of the electrodes. The luminescent layer includes the iridium complex compound of the present invention.

The luminescent layer preferably further contains a charge-transporting non-conjugated polymer compound.
The charge-transporting non-conjugated polymer compound is preferably a polymer obtained by copolymerizing monomers including at least one polymerizable compound selected from the group consisting of hole-transporting polymerizable compounds and electron-transporting polymerizable compounds. In the present specification, the hole-transporting polymerizable compounds and the electron-transporting polymerizable compounds are collectively referred to as the charge-transporting polymerizable compounds.

That is, the charge-transporting non-conjugated polymer compound described above is preferably a polymer comprising a structural unit derived from at least one hole-transporting polymerizable compound or a structural unit derived from at least one electron-transporting polymerizable compound. The use of this polymer provides advantages that the charge mobility in the luminescent layer is high, and the luminescent layer can be formed with uniformity in small thickness by coating and therefore high luminous efficiency is obtained.

Further, the charge-transporting non-conjugated polymer compound described above is more preferably a polymer comprising a structural unit derived from at least one hole-transporting polymerizable compound and a structural unit derived from at least one electron-transporting polymerizable compound. Because this polymer is endowed with a hole-transporting property and an electron-transporting property, holes and electrons are more efficiently recombined in the vicinity of the iridium complex compound, and therefore higher luminous efficiency is obtained.

The hole-transporting polymerizable compound and the electron-transporting polymerizable compound are not particularly limited as long as they have a polymerizable functional group, and publicly known charge-transporting compounds can be used.
The polymerizable functional group described above may be any of radically polymerizable, cationically polymerizable, anionically polymerizable, addition-polymerizable and condensation-polymerizable functional groups. Among them, the radically polymerizable functional group is preferred since the polymer is easily produced.

Examples of the polymerizable functional groups include alkenyl groups, acrylate group, methacrylate group, urethane (meth)acrylate groups such as methacryloyloxyethyl carbamate, vinylamide groups and derivatives thereof. Among them, alkenyl groups are preferred.

Preferred examples of the alkenyl groups as the polymerizable functional groups include those represented by the following Formulas (A1) to (A12). Among them, the substituents represented by the Formulas (A1), (A5), (A8) and (A12) are more preferred since such functional groups can readily be introduced into the charge-transporting compounds.

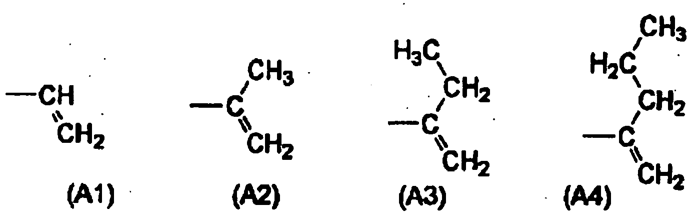

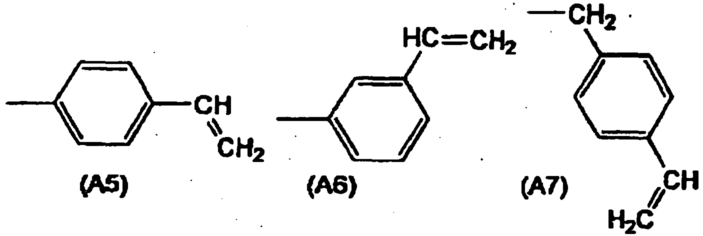

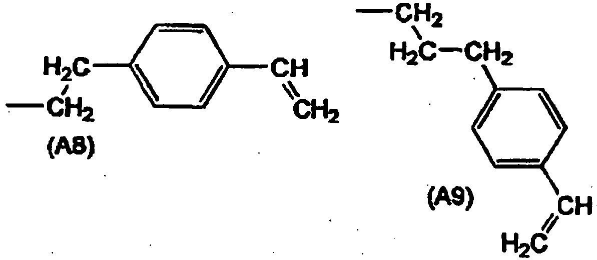

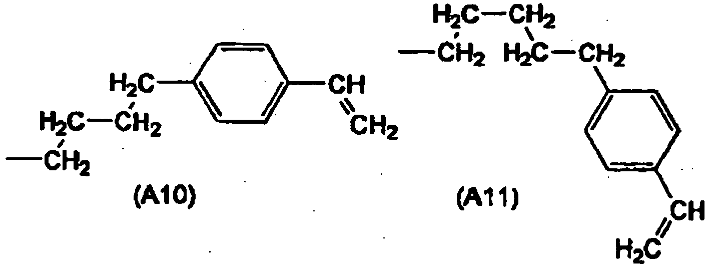

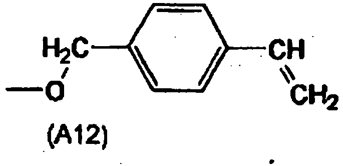

Preferred examples of the hole-transporting polymerizable compounds include compounds represented by the following Formulas (E1) to (E6). In particular, the compounds represented by the following Formulas (E1) to (E3) are more preferred from the viewpoint of charge mobility in the non-conjugated polymer compound.

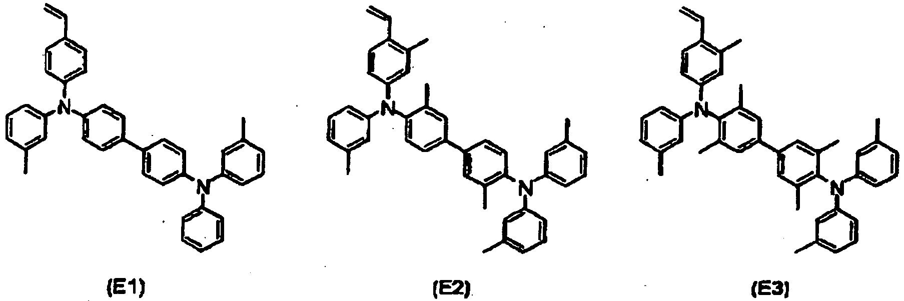

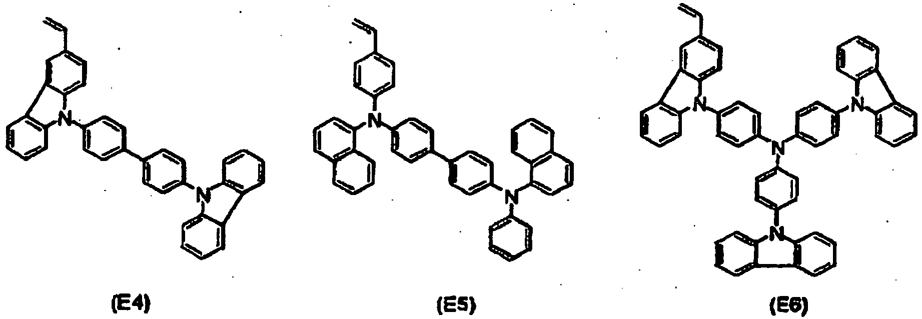

Preferred examples of the electron-transporting polymerizable compounds include compounds represented by the following Formulas (E7) to (E15). In particular, the compounds represented by the following Formulas (E7) and (E12) to (E14) are more preferred from the viewpoint of charge mobility in the non-conjugated polymer compound.

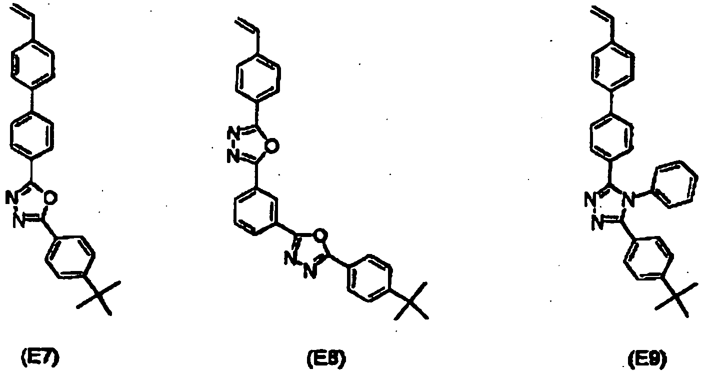

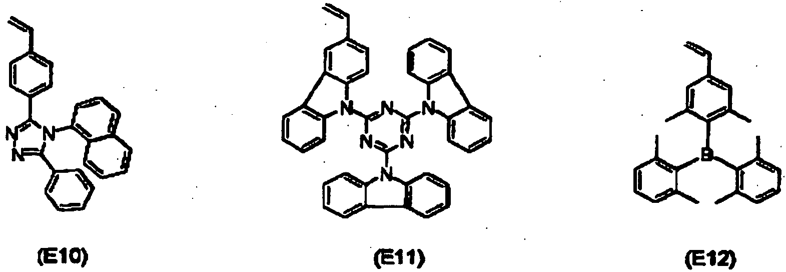

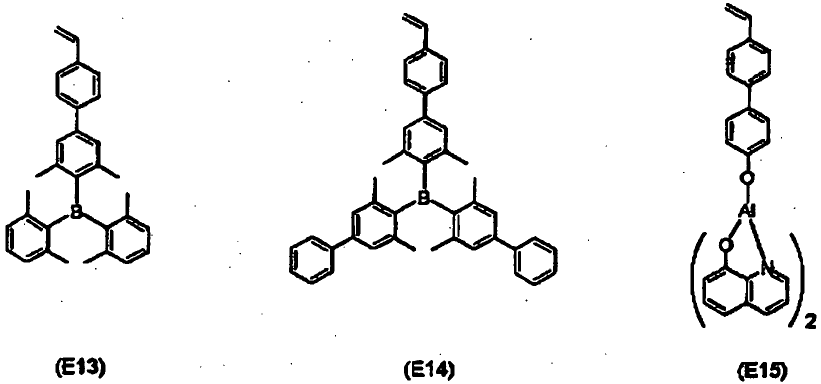

Compounds corresponding to Formulas (E1) to (E15) except that the substituent represented by Formula (A1) is altered to the substituents represented by Formulas (A2) to (A12) are suitably used as well. In particular, the compounds having the substituents represented by Formulas (A1) and (A5) are preferable since the functional groups can readily be introduced into the polymerizable compounds.

More preferably, the hole-transporting polymerizable compound represented by any of the foregoing Formulas (E1) to (E3) and the electron-transporting polymerizable compound represented by any of the foregoing Formulas (E7) and (E12) to (E14) are copolymerized. The obtainable non-conjugated polymer compound provides advantages that holes and electrons are more efficiently recombined on the iridium complex compound, and higher luminous efficiency is obtained. Further, the obtainable non-conjugated polymer compound together with the iridium complex compound can form an evenly distributed organic layer, and the organic EL device shows excellent durability.

In the organic EL device according to the present invention, the organic layer (luminescent layer) includes the iridium complex compound and the non-conjugated polymer compound. In the organic layer, the iridium complex compound is dispersed in a matrix formed by the non-conjugated polymer compound. Consequently, the organic layer can emit light which is usually difficult to produce, that is, light which is emitted through a triplet excitation state of the iridium complex compound. Accordingly, the organic layer enables high luminous efficiency.

The charge-transporting non-conjugated polymer compound described above may further contain a structural unit derived from other polymerizable compounds while still achieving the object of the present invention. Examples of such polymerizable compounds include, but are not limited to, compounds having no charge-transporting property such as (meth)acrylic acid alkyl esters including methyl acrylate and methyl methacrylate, styrene and derivatives thereof.

The charge-transporting non-conjugated polymer compound described above preferably has a weight average molecular weight of 1,000 to 2,000,000, more preferably 5,000 to 1,000,000. The molecular weight in the present specification is a polystyrene-equivalent molecular weight measured by GPC (gel permeation chromatography). When the molecular weight falls in the above range, the polymer is soluble in organic solvents, and a homogeneous thin film is obtained.

The charge-transporting non-conjugated polymer compound may be any of a random copolymer, a block copolymer and an alternating copolymer.
The charge-transporting non-conjugated polymer compound described above may be produced by any of radical polymerization, cationic polymerization, anionic polymerization and addition polymerization. The radical polymerization is preferred.

One example of the structures of the organic EL devices according to the present invention is shown in Fig. 1, but the structure of the organic EL device according to the present invention is not limited thereto. In Fig. 1, a luminescent layer (3) is provided between an anode (2) and a cathode (4) which are provided on a transparent substrate (1). In the organic EL device, a hole-injecting layer may be provided between the anode (2) and the luminescent layer (3), and an electron-injecting layer may be provided between the luminescent layer (3) and the cathode (4).

The organic layer including the iridium complex compound and the charge-transporting non-conjugated polymer compound can be used as a luminescent layer having both a hole-transporting property and an electron-transporting property. This provides an advantage that the organic EL device shows high luminous efficiency without other organic material layers.

The organic layer may be produced without limitation, for example as follows. First, a solution of the iridium complex compound and the charge-transporting non-conjugated polymer compound is prepared. The solvent used herein is not particularly limited. Examples of the solvents include chlorine based solvents such as chloroform, methylene chloride and dichloroethane, ether based solvents such as tetrahydrofuran and anisole, aromatic hydrocarbon based solvents such as toluene and xylene, ketone based solvents such as acetone and methyl ethyl ketone, and ester based solvents such as ethyl acetate, butyl acetate and ethyl cellosolve acetate. Next, the solution prepared as described above is applied on a substrate to form a film. Herein, any of an ink jet method, a spin coating method, a dip coating method and a printing method may be employed. The concentration of the solution depends on the compounds used, the solvent, the film-forming conditions and the like. In the case of, for example, the spin coating method and the dip coating method, the concentration is preferably 0.1 to 10 wt%. Further, the concentration of the iridium complex compound in the solution is preferably 0.001 to 5 wt%.
As shown above, the organic layer is easily formed, and therefore the production step can be simplified and production of large-area organic EL devices is enabled.

### <Other materials>

The layers in the EL device may be formed using a polymer material as a binder. Examples of the polymer materials include polymethyl methacrylate, polycarbonate, polyester, polysulfone and polyphenylene oxide.

Further, the layers may be formed by mixing materials having different functions, for example, a luminescent material, a hole-transporting material, an electron-transporting material and the like. The organic layer including the iridium complex compound and the non-conjugated polymer compound may further contain other hole-transporting material and/or electron-transporting material for the purpose of supplementing the charge-transporting property. Such transporting materials may be low molecular weight compounds or polymer compounds.

Examples of the hole-transporting materials for forming the hole-transporting layer and of the hole-transporting materials mixed in the luminescent layer include low molecular weight triphenylamine derivatives such as TPD (N,N'-dimethyl-N,N'-(3-methylphenyl)-1,1'-biphenyl-4,4'-diamine, α-NPD (4,4'-bis[N-(1-naphthyl)-N-phenylamino]biphenyl) and m-MTDATA (4,4',4"-tris(3-methylphenylamino)triphenylamine); polyvinylcarbazole; polymer compounds prepared by polymerizing the triphenylamine derivatives described above into which polymerizable substituents are introduced; and fluorescent polymer compounds such as polyparaphenylenevinylene and polydialkylfluorene. The polymer compounds described above include, for example, polymer compounds having a triphenylamine skeleton disclosed in Japanese Patent Application Laid-Open No. 157575/1996. The hole-transporting materials may be used singly or in a mixture of two or more kinds, and different hole-transporting materials may be used as a laminate. The thickness of the hole-transporting layer depends on conductivity of the hole-transporting layer and is variable. Preferably, the thickness is 1 nm to 5 µm, more preferably 5 nm to 1 µm, and particularly preferably 10 nm to 500 nm.

Examples of the electron-transporting materials for forming the electron-transporting layer and of the electron-transporting materials mixed in the luminescent layer include low molecular weight compounds such as oxadiazole derivatives, triazole derivatives, imidazole derivatives, triazine derivatives, triarylborane derivatives and quinolinol derivative metal complexes such as Alq3 (aluminum trisquinolinolate); and polymer compounds prepared by polymerizing the low molecular weight compounds described above into which polymerizable substituents are introduced. The polymer compounds described above include, for example, poly-PBD disclosed in Japanese Patent Application Laid-Open No. 1665/1998. The electron-transporting materials may be used singly or in a mixture of two or more kinds, and different electron-transporting materials may be used as a laminate. The thickness of the electron-transporting layer depends on conductivity of the electron-transporting layer and is variable. Preferably, the thickness is 1 nm to 5 µm, more preferably 5 nm to 1 µm, and particularly preferably 10 nm to 500 nm.

A hole-blocking layer may be provided adjacent to the luminescent layer on the cathode side for the purposes of inhibiting the holes from passing through the luminescent layer and of allowing the holes and electrons to recombine efficiently in the luminescent layer. The hole-blocking layer may be produced using publicly known materials such as triazole derivatives, oxadiazole derivatives and phenanthroline derivatives.

A hole-injecting layer may be provided between the anode and the luminescent layer in order to facilitate the injection of holes (to reduce the injection barrier). The hole-injecting layer may be produced using publicly known materials such as copper phthalocyanine, a mixture of polyethylenedioxythiophene (PEDOT) and polystyrenesulfonic acid (PSS), fluorocarbon and the like.

An insulating layer having a thickness of 0.1 to 10 nm may be provided between the cathode and the electron-transporting layer or between the cathode and the organic layer laminated adjacent to the cathode to improve electron-injecting efficiency. The insulating layer may be formed using publicly known materials such as lithium fluoride, magnesium fluoride, magnesium oxide and alumina.

The anode may be formed of publicly known transparent conductive materials such as ITO (indium tin oxide), tin oxide, zinc oxide, and conductive polymers including polythiophene, polypyrrole and polyaniline. The electrode formed of the transparent conductive material preferably has a surface resistance of 1 to 50 Ω/square. The anode preferably has a thickness of 50 to 300 nm.

The cathode may be formed of publicly known cathode materials such as alkali metals such as Li, Na, K and Cs; alkali earth metals such as Mg, Ca and Ba; Al; MgAg alloys; and alloys of Al and alkali metals or alkali earth metals such as AlLi and AlCa. The cathode preferably has a thickness of 10 nm to 1 µm, more preferably 50 to 500 nm. When the cathode is formed using a metal having high activity such as alkali metal or alkali earth metal, the thickness of the cathode is preferably 0.1 to 100 nm, more preferably 0.5 to 50 nm. In this case, a metal layer which is stable to air is laminated on the cathode for the purpose of protecting the cathode metal. Examples of the metals for forming the metal layer include Al, Ag, Au, Pt, Cu, Ni and Cr. The metal layer preferably has a thickness of 10 nm to 1 µm, more preferably 50 to 500 nm.

The substrate of the organic EL device may be an insulating substrate which is transparent at an emission wavelength of the luminescent material. Examples include glass, and transparent plastics such as PET (polyethylene terephthalate) and polycarbonate.

Exemplary methods for forming the hole-transporting layer, the luminescent layer and the electron-transporting layer include a resistance heating vapor deposition method, an electron beam vapor deposition method, a sputtering method, an ink jet method, a spin coating method, a printing method, a spray method, and a dispenser method. In the case of the low molecular weight compounds, the resistance heating vapor deposition method or the electron beam vapor deposition method is suitably used. In the case of the polymer compounds, the ink jet method, the spin coating method or the printing method is suitably used.

Exemplary methods for forming the anode include an electron beam vapor deposition method, a sputtering method, a chemical reaction method and a coating method. Exemplary methods for forming the cathode include a resistance heating vapor deposition method, an electron beam vapor deposition method, a sputtering method and an ion plating method.

### Uses:

The organic EL device according to the present invention is suitably used as pixels for known image display devices of matrix type or segment type. Further, the organic EL device is suitably used as a plane light source without forming pixels.

Specifically, the organic EL device according to the present invention is suitably used for display devices in computers, televisions, mobile terminals, portable phones, car navigation systems, viewfinders of video cameras and the like, and for backlights, light sources of electrophotography, light sources of illumination, light sources of recording, light sources of exposure, light sources of reading, indicators, advertising displays, interiors, optical communications and the like.

### EXAMPLES

The present invention will be explained below with reference to examples, but the present invention is not limited to these examples.

### <Measuring apparatus and the like>

1) ¹H-NMR
   Apparatus: JNM EX270, manufactured by JEOL Ltd. 270 MHz, solvent: deuterated chloroform
2) Elemental analyzer
   CHNS-932, manufactured by RECO Co., Ltd.

### Example 1

### Synthesis of iridium complex compound (A)

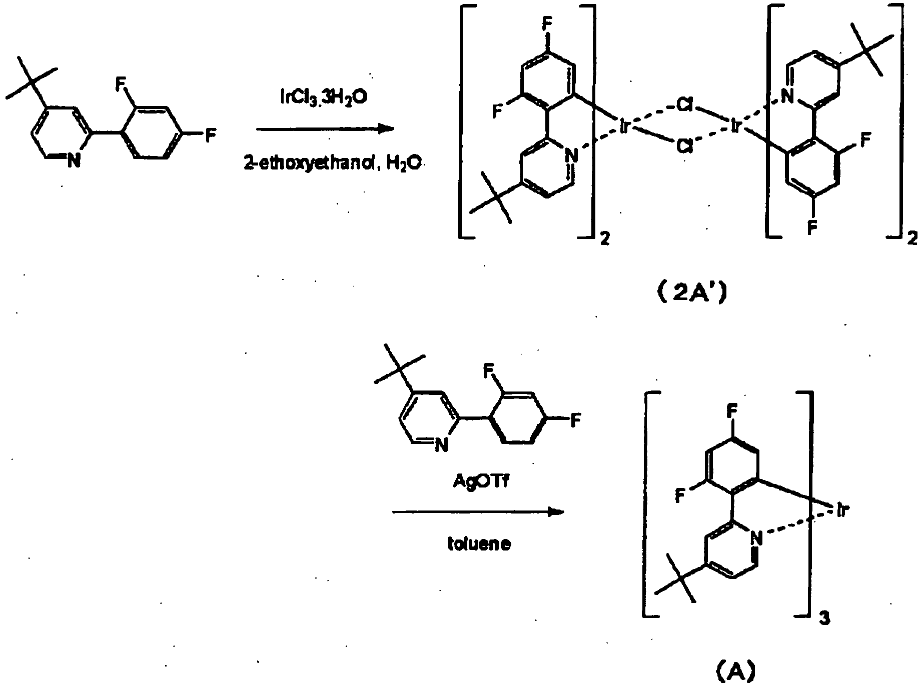

Explanations shall be given with reference to the scheme shown above.

### <Synthesis of compound (2A')>

A 50-ml two necked flask equipped with a Dimroth condenser and a three-way cock was charged with 371 mg of 2-(2',4'-difluorophenyl)-4-tertiary butylpyridine synthesized by a method described in Polyhedron 25, 1167 (2006), 212 mg of iridium (III) chloride trihydrate, 9 ml of 2-ethoxyethanol and 3 ml of purified water. The solution was bubbled with nitrogen for 5 minutes. Then, the solution was refluxed for 14 hours under nitrogen atmosphere with stirring to react the compounds described above. After the reaction, the reaction liquid was cooled to room temperature, and 30 ml of purified water was added thereto to precipitate the product. The precipitate was filtered and washed with 50 ml of a mixed solvent of methanol/water = 7/3, and then it was dried under reduced pressure to give a compound (2A') in the form of yellow powder. The compound weighed 367 mg, and the yield was 85%. The compound was used directly for the subsequent step without identification.

### <Synthesis of iridium complex compound (A)>

A 50-ml two necked flask equipped with a Dimroth condenser and a three-way cock was charged with 288 mg of the compound (2A') and 124 mg of 2-(2',4'-difluorophenyl)-4-tertiary butylpyridine. The flask was purged with nitrogen. Thereafter, 3 ml of dehydrated toluene and 129 mg of silver (I) trifluoromethanesulfonate were added. The mixture was refluxed for 5 hours with stirring to react these compounds. After the reaction, the reaction liquid was cooled to room temperature, and chloroform was added thereto, followed by washing with an aqueous sodium chloride solution. The organic layer obtained was dried over magnesium sulfate and then filtered, and the solvent was removed by evaporation. The residue was purified by silica gel column chromatography (eluent: gradient from hexane to chloroform/hexane = 2/1) to remove impurities other than the iridium complex. The iridium complex was chromatographed on silica gel (eluent: gradient from chloroform/hexane = 1/9 to 2/8) and was separated,into a fraction 1 (mer complex) and a fraction 2 (fac complex). The respective fractions were recrystallized from a mixed solvent of methanol and dichloromethane. Consequently, the mer complex was obtained in the form of a yellow crystal and the fac complex was obtained in the form of a yellow fine crystal. The mer complex weighed 127 mg, and the yield thereof was 34%. The fac complex weighed 125 mg, and the yield thereof was 34%. The identification was made by ¹H-NMR and CHN elemental analysis.

### mer complex:

¹H-NMR (270 MHz, CDCl₃) ppm: 8.34 (m, 1H, ArH), 8.22 (m, 2H, ArH), 7.89 (d, 1H, J = 6.2 Hz, ArH), 7.79 (d, 1H, J = 5.9 Hz, ArH), 7.30 (d, 1H, J = 6.5 Hz, ArH), 6.96 (dd, 1H, J = 5.7, 2.2 Hz, ArH), 6.83 (m, 2H, ArH), 6.46 to 6.35 (m, 4H, ArH), 5.95 (dd, 1H, J = 7.4, 2.3 Hz, ArH), 5.74 (dd, 1H, J = 9.3, 2.3 Hz, ArH), 1.34 (s, 9H, -C(CH₃)₃), 1.33 (s, 18H, - C(CH₃)₃)

### Elemental analysis

Analyzed value: C 58.02, H 4.64, N 4.50
Calculated value: C 58.05, H 4.55, N 4.51

### fac complex:

¹H-NMR (270 MHz, CDCl₃) ppm: 8.30 (m, 3H, ArH), 7.32 (d, 3H, J = 5.9 Hz, ArH), 6.94 (dd, 3H, J = 6.1, 2.0 Hz, ArH), 6.39 (m, 3H, ArH), 6.28 (dd, 3H, J = 9.3, 2.3 Hz, ArH), 1.34 (s, 27H, -C(CH₃)₃)

### Elemental analysis

Analyzed value: C 58.07, H 4.61, N 4.56
Calculated value: C 58.05, H 4.55, N 4.51

### Example 2 (for reference only) Synthesis of iridium complex compound (B)

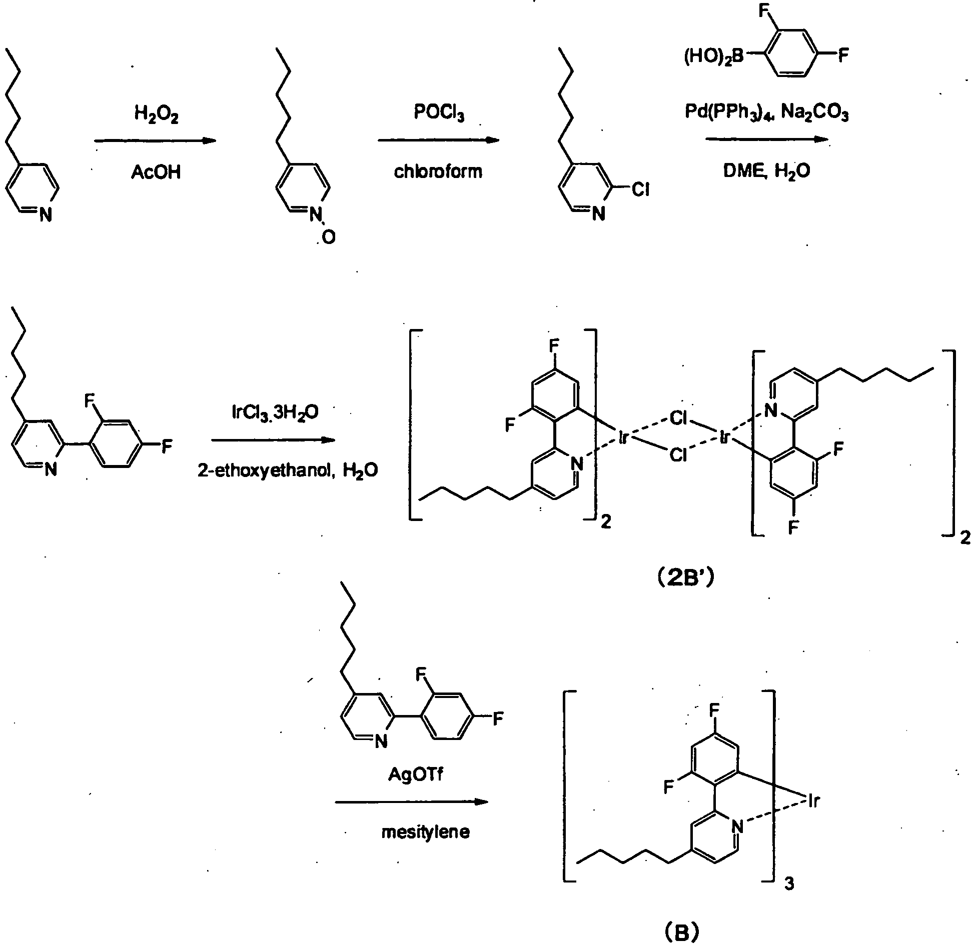

Explanations shall be given with reference to the scheme shown above.

### <Synthesis of 4-n-amylpyridine-N-oxide>

A 500-ml recovery flask equipped with a condenser tube was charged with 4-n-amylpyridine (5.0 g, 33.5 mmol), acetic acid (50 ml) and a 30% hydrogen peroxide solution (10 ml). The mixture was stirred at 80°C for 2 hours. Further, a 30% hydrogen peroxide solution (5 ml) was added thereto, and the mixture was stirred at 80°C for 13 hours to carry out reaction. After the reaction, the solvent was removed by evaporation under reduced pressure, and the resultant concentrate was combined with chloroform. The resulting mixture was washed with an aqueous 1N sodium hydroxide solution and an aqueous sodium chloride solution. The organic layer obtained was dried over magnesium sulfate and then filtered, and the solvent was removed by evaporation. The residue was purified by alumina column chromatography (eluent: gradient from chloroform/hexane = 1/1 to chloroform and to methanol/chloroform = 1/9), and then the solvent was removed by evaporation. The residue was dried under reduced pressure to give 4-n-amylpyridine-N-oxide in the form of a colorless liquid. The product weighed 5.53 g, and the yield was 100%.
¹H-NMR (270 MHz, CDCl₃) ppm: 8.13 (d, 2H, J = 7.0 Hz, ArH), 7.08 (d, 2H, J = 6.8 Hz, ArH), 2.60 (t, 2H, J = 7.7 Hz, - CH₂-), 1.62 (m, 2H, -CH₂-), 1.32 (m, 4H, -CH₂-), 0.90 (t, 3H, J = 6.9 Hz, -CH₃)

### <Synthesis of 4-n-amyl-2-chloropyridine>

A 200-ml recovery flask equipped with a condenser tube was charged with 4-n-amylpyridine-N-oxide (5.53 g, 33.5 mmol) and was purged with nitrogen. Chloroform (20 ml) and phosphorus oxychloride (31.2 ml, 335 mmol) were added thereto slowly and carefully, and then the mixture was refluxed for 18 hours with stirring to carry out reaction. After the reaction, the solvent and unreacted phosphorus oxychloride were removed by evaporation under reduced pressure. The resultant concentrate was poured into ice water. The mixture was neutralized with an aqueous sodium hydroxide solution, and then the reaction product was extracted with chloroform. The organic layer obtained was dried over magnesium sulfate and then filtered, and the solvent was removed by evaporation. The residue was purified by silica gel column chromatography (eluent: gradient from chloroform/hexane = 1/1 to chloroform), and then the solvent was removed by evaporation. The residue was dried under reduced pressure to give 4-n-amyl-2-chloropyridine in the form of a colorless oil. The product weighed 2.22 g, and the yield was 36%.
¹H-NMR (270 MHz, CDCl₃) ppm: 8.26 (d, 1H, J = 4.9 Hz, ArH), 7.15 (s, 1H, ArH), 7.03 (d, 1H, J = 5.4 Hz, ArH), 2.59 (t, 2H, J = 7.6 Hz, -CH₂-), 1.63 (m, 2H, -CH₂-), 1.32 (m, 4H, - CH₂-), 0.90 (t, 3H, J = 7.0 Hz, -CH₃)

### <Synthesis of 2-(2',4'-difluorophenyl)-4-n-amylpyridine>

A 100-ml three necked flask equipped with a Dimroth condenser and a three-way cock was charged with 4-n-amyl-2-chloropyridine (2.22 g, 12.1 mmol), 2,4-difluorophenylboronic acid (2.29 g, 14.5 mmol), sodium carbonate (2.57 g, 24.2 mmol), 1,2-dimethoxyethane (36 ml) and purified water (12 ml). The mixture was bubbled with nitrogen. Tetrakis(triphenylphosphine)palladium (0) (280 mg, 0.24 mmol) was added thereto, and the mixture was refluxed for 2 hours with stirring to carry out reaction. After the reaction, the reaction liquid was cooled to room temperature, and ethyl acetate was added thereto, followed by washing with an aqueous sodium chloride solution. The organic layer obtained was dried over magnesium sulfate and then filtered, and the solvent was removed by evaporation. The residue was purified by silica gel column chromatography (eluent: gradient from chloroform/hexane = 1/1 to chloroform), and then the solvent was removed by evaporation. The residue was dried under reduced pressure to give 2-(2',4'-difluorophenyl)-4-n-amylpyridine in the form of a colorless oil. The product weighed 2.21 g, and the yield was 70%.
¹H-NMR (270 MHz, CDCl₃) ppm: 8.57 (d, 1H, J = 4.9 Hz, ArH), 7.96 (m, 1H, ArH), 7.55 (s, 1H, ArH), 7.08 (d, 1H, J = 5.1 Hz, ArH), 7.02 to 6.86 (m, 2H, ArH), 2.66 (t, 2H, J = 7.8 Hz, -CH₂-), 1.67 (m, 2H, -CH₂-), 1.34 (m, 4H, -CH₂-), 0.91 (t, 3H, J = 6.8 Hz, -CH₃)

### <Synthesis of compound (2B')>

A 50-ml two necked flask equipped with a Dimroth condenser and a three-way cock was charged with 2-(2',4'-difluorophenyl)-4-n-amylpyridine (627 mg, 2.4 mmol), iridium chloride trihydrate (353 mg, 1.0 mmol), 2-ethoxyethanol (15 ml) and purified water (5 ml). The mixture was bubbled with nitrogen. Then, the mixture was refluxed for 17 hours with stirring to carry out reaction. After the reaction, the reaction liquid was cooled to room temperature, and purified water was added thereto to precipitate the product. The precipitate was filtered and washed with methanol, and then it was dried under reduced pressure to give a compound (2B') in the form of yellow powder. The compound weighed 696 mg, and the yield was 93%.

### <Synthesis of iridium complex compound (B)>

A 50-ml two necked flask equipped with a Dimroth condenser and a three-way cock was charged with the compound (2B') (299 mg, 0.2 mmol), potassium carbonate (138 mg, 1.0 mmol) and 2-(2',4'-difluorophenyl)-4-n-amylpyridine (131 mg, 0.5 mmol), and the flask was purged with nitrogen. Mesitylene (4 ml) and silver (I) trifluoromethanesulfonate (123 mg, 0.48 mmol) were added, and then the mixture was refluxed for 3 hours with stirring to react these compounds. After the reaction, the reaction liquid was cooled to room temperature, and chloroform was added thereto. The mixture was filtered through Celite to remove insoluble matters. The solvent was evaporated from the filtrate, and the residue was purified by silica gel column chromatography (eluent: gradient from chloroform/hexane = 1/3 to 1/1), then recrystallized twice from methanol/dichloromethane and dried under vacuum to give an iridium complex compound (B) in the form of a yellow fine crystal. The compound weighed 368 mg, and the yield was 95%. ¹H-NMR showed that the compound provided no peaks corresponding to a meridional complex and that the whole of the compound was a facial complex.
¹H-NMR (270 MHz, CDCl₃) ppm: 8.09 (s, 3H, ArH), 7.29 (d, 3H, J = 5.7 Hz, ArH), 6.74 (d, 3H, J = 4.1 Hz, ArH), 6.37 (m, 3H, ArH), 6.26 (dd, 3H, J = 9.2, 2.7 Hz, ArH), 2.65 (t, 6H, J = 7.8 Hz, -CH₂-), 1.65 (m, 6H, -CH₂-), 1.35 (m, 12H, -CH₂-), 0.90 (t, 9H, J = 6.8 Hz, -CH₃)

### Elemental analysis

Analyzed value: C 58.97, H 5.01, N 4.40
Calculated value: C 59.24, H 4.97, N 4.32

### Example 3 (for reference only)

### Synthesis of iridium complex compound (C)

An iridium complex compound (C) was synthesized according to the same synthetic scheme as in Example 2, except that 4-(5-nonyl)pyridine (4.62 g, 22.5 mmol) was used in place of 4-n-amylpyridine. ¹H-NMR showed that the compound provided no peaks corresponding to a meridional complex and that the whole of the compound was a facial complex.
¹H-NMR (270 MHz, CDCl₃) ppm: 8.06 (s, 3H, ArH), 7.21 (d, 3H, J= 5.9 Hz, ArH), 6.68 (dd, 3H, J = 7.3, 1.6 Hz, ArH), 6.39 (m, 3H, ArH), 6.33 (dd, 3H, J = 9.0, 2.3 Hz, ArH), 2.53 (m, 3H, -CH-), 1.72 to 1.51 (m, 12H, -CH₂-), 1.30 to 1.07 (m, 24H, -CH₂-), 0.84 (td, 18H, J = 7.0, 2.2 Hz, -CH₃)

### Elemental analysis

Analyzed value: C 63.24, H 6.35, N 3.59
Calculated value: C 63.13, H 6.36, N 3.68

### Example 4

### Synthesis of iridium complex compound (D)

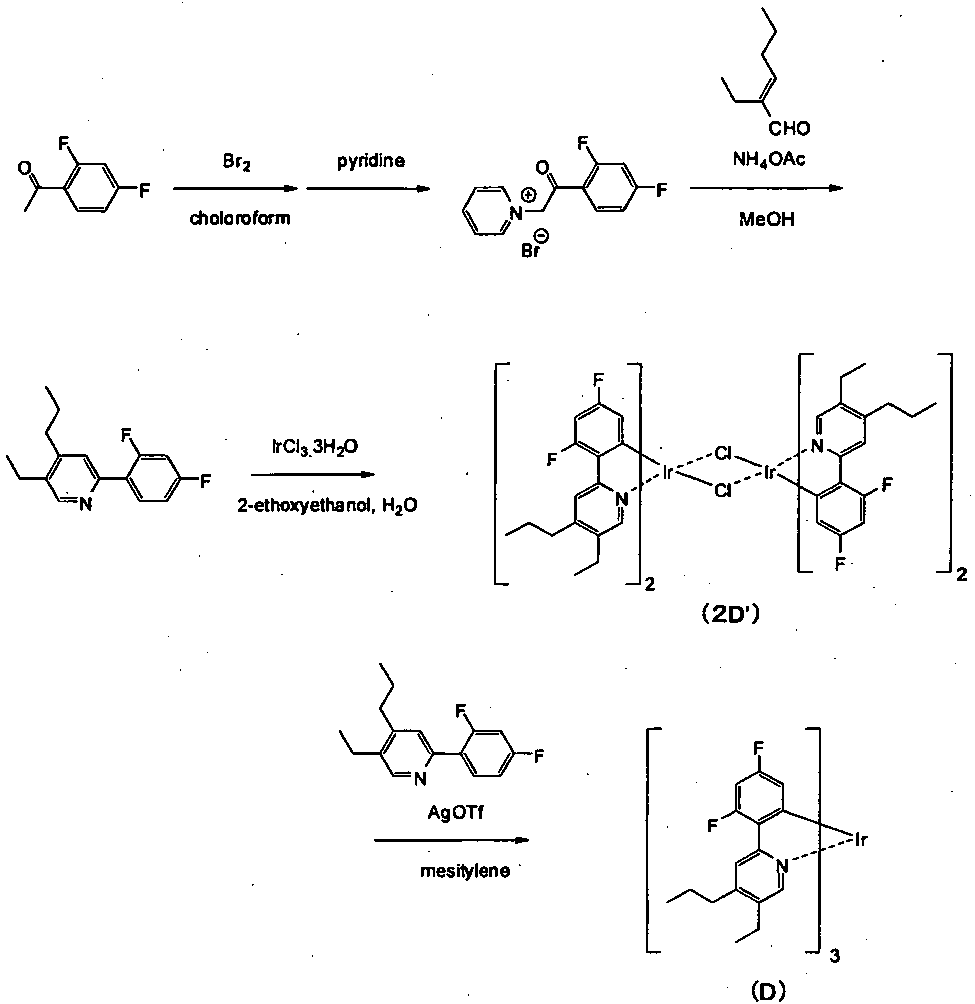

Explanations shall be given with reference to the scheme shown above.

### <Synthesis of 1-[2-(2,4-difluorophenyl)-2-oxoethyl]pyridinium bromide>

A 200-ml two necked flask equipped with a dropping funnel and a three-way cock was charged with 2',4'-difluorophenylacetophenone (10.0 g, 64 mmol) and dehydrated chloroform (50 ml) under nitrogen atmosphere, and a dehydrated chloroform (10 ml) solution of bromine (10.24 g, 64 mmol) was added dropwise in 30 minutes with stirring. After the dropwise addition, the mixture was stirred continuously at room temperature for one hour to carry out reaction. After the reaction, purified water and a 1 mol/l aqueous sodium thiosulfate solution (100 ml) were added, and the reaction product was extracted with chloroform. The organic layer obtained was dried over magnesium sulfate and then filtered, and the solvent was removed by evaporation. Consequently, crude 2-bromo-1-(2,4-difluorophenyl)ethanone was obtained. Pyridine (60 ml) was added thereto under nitrogen atmosphere, and the mixture was stirred at room temperature for 3 hours to carry out reaction. After the reaction, diethyl ether (100 ml) was added, and the precipitate was filtered and washed with diethyl ether. The product was dried under vacuum to give 1-[2-(2,4-difluorophenyl)-2-oxoethyl]pyridinium bromide in the form of a pale brown solid. The product weighed 17.8 g, and the yield was 89%.

### <Synthesis of 2-(2,4-difluorophenyl)-5-ethyl-4-propylpyridine>

A 200-ml two necked flask equipped with a Dimroth condenser and a three-way cock was charged with 1-[2-(2,4-difluorophenyl)-2-oxoethyl]pyridinium bromide (4.08 g, 13.0 mmol) and ammonium acetate (10.02 g, 130 mmol), and the flask was purged with nitrogen. Dehydrated methanol (10 ml) and 2-ethyl-2-hexenal (1.64 g, 13.0 mmol) were added, and the mixture was refluxed for 37 hours with stirring to carry out reaction. After the reaction, water was added, and the reaction product was extracted with chloroform. The organic layer obtained was dried over magnesium sulfate and then filtered, and the solvent was removed by evaporation. The residue was purified by medium pressure silica gel column chromatography (eluent: chloroform), and the solvent was removed by evaporation. The residue was dried under reduced pressure to give 2-(2,4-difluorophenyl)-5-ethyl-4-propylpyridine in the form of a colorless liquid. The product weighed 1.40 g, and the yield was 41%.
¹H-NMR (270 MHz, CDCl₃) ppm: 8.46 (s, 1H, ArH), 7.94 (m, 1H, ArH), 7.50 (d, 1H, J = 2.4 Hz, ArH), 6.98 (m, 1H, ArH), 6.90 (m, 1H, ArH), 2.70 (q, 2H, J = 7.6 Hz, ArCH2), 2.65 (t, 2H, J = 7.7 Hz, ArCH₂), 1.68 (m, 2H, -CH₂-), 1.27 (t, 3H, J =7.6 Hz, -CH₃), 1.02 (t, 3H, J = 7.4 Hz, -CH₃)

### <Synthesis of compound (2D')>

A 50-ml two necked flask equipped with a Dimroth condenser and a three-way cock was charged with 2-(2,4-difluorophenyl)-5-ethyl-4-propylpyridine (627 mg, 2.4 mmol), iridium chloride trihydrate (353 mg, 1.0 mmol), 2-ethoxyethanol (15 ml) and purified water (5 ml), and the mixture was bubbled with nitrogen. Then, the mixture was refluxed for 38 hours with stirring to carry out reaction. After the reaction, the reaction liquid was cooled to room temperature, and purified water was added thereto to precipitate the product. The precipitate was filtered and washed with methanol, and then it was dried under reduced pressure to give a compound (2D') in the form of yellow powder. The compound weighed 695 mg, and the yield was 93%.

### <Synthesis of iridium complex compound (D)>

A 50-ml two necked flask equipped with a Dimroth condenser and a three-way cock was charged with the compound (2D') (299 mg, 0.2 mmol), potassium carbonate (138 mg, 1.0 mmol) and 2-(2,4-difluorophenyl)-5-ethyl-4-propylpyridine (131 mg, 0.25 mmol), and the flask was purged with nitrogen. Dehydrated mesitylene (4 ml) and silver (I) trifluoromethanesulfonate (123 mg, 0.48 mmol) were added, and then the mixture was refluxed for 3 hours with stirring to react these compounds. After the reaction, the reaction liquid was cooled to room temperature, and chloroform was added. The mixture was filtered through Celite. The filtrate was concentrated under reduced pressure, and the concentrate was purified by medium pressure silica gel column chromatography (eluent: gradient from chloroform/hexane = 5/95 to chloroform) and then recrystallized from a methanol/dichloromethane mixed solvent to give an iridium complex compound (D) in the form of a yellow fine crystal. The product weighed 359 mg, and the yield was 93%. ¹H-NMR showed that the compound provided no peaks corresponding to a meridional complex and that the whole of the compound was a facial complex. ¹H-NMR (270 MHz, CDCl₃) ppm: 8.03 (d, 3H, J = 2.4 Hz, ArH), 7.07 (s, 3H, ArH), 6.40 (dd, 3H, J = 8.9, 2.4 Hz, ArH), 6.35 (d, 3H, J = 9.5 Hz, ArH), 2.63 (t, 6H, J = 7.6 Hz, ArCH₂), 2.55 to 2.32 (m, 6H, ArCH₂) ; 1.65 (m, 6H, -CH₂-), 1.01 (t, 9H, J=7.2 Hz, -CH₃), 0.92 (t, 9H, J=7.4 Hz, CH₃)

### Elemental analysis

Analyzed value: C 59.47, H 4.86, N 4.34
Calculated value: C 59.24, H 4.97, N 4.32

### Example 5

### Solubility test

The facial and meridional iridium complex compounds (A) synthesized in Example 1 and the facial iridium complex compounds (B) to (D) synthesized in Examples 2 to 4 (Examples 2 and 3 for reference) were tested for solubility. The results are shown in Table 1. The test was carried out by mixing the iridium complex compound with chloroform or toluene so that a prescribed concentration was obtained, and visually determining if the iridium complex compound was completely dissolved or partially undissolved after the mixture had been stirred at room temperature for one hour.

### Comparative Example 1

Iridium complex compounds Ir(ppy)₃ (the following Formula (Y)) and Ir(Fppy)₃ (the following Formula (X)) were tested for solubility. The results are shown in Table 1. The test was carried out by mixing the iridium complex compound with chloroform or toluene so that a prescribed concentration was obtained, and visually determining if the iridium complex compound was completely dissolved or partially undissolved after the mixture had been stirred at room temperature for one hour.

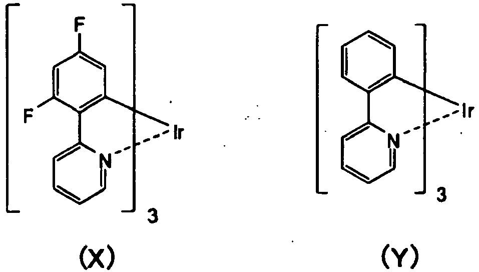

**Table 1**

| Material | Solvent | Concentration | | |
|---|---|---|---|---|
| | | 0.1 wt% | 0.5 wt% | 1 wt% |
| Compound (A) facial complex | Chloroform | A | A | A |
| | Toluene | A | B | B |
| Compound (A) meridional complex | Chloroform | A | A | A |
| | Toluene | A | A | A |
| Compound (B) (reference) facial complex | Chloroform | A | A | A |
| | Toluene | A | B | B |
| Compound (C) (reference) facial complex | Chloroform | A | A | A |
| | Toluene | A | A | B |
| Compound (D) facial complex | Chloroform | A | A | A |
| | Toluene | A | A | A |
| Ir(Fppy)₃ facial complex | Chloroform | A | B | B |
| | Toluene | B | B | B |
| Ir(ppy)₃ facial complex | Chloroform | A | B | B |
| | Toluene | B | B | B |

| | | | | |
|---|---|---|---|---|
| A: completely dissolved B: partially undissolved | | | | |

The results shown in Table 1 prove that the iridium complex compounds (A) and (D) of the present invention have high solubility in the organic solvents as compared with conventional blue light emitting iridium complex compound Ir(Fppy)₃ and conventional green light emitting iridium complex compound Ir(ppy)₃.

### Example 6

### Production of organic EL device:

An organic EL device was produced with use of a substrate (manufactured by Nippo Electric Co., Ltd.) provided with ITO (indium tin oxide) which was composed of a 25 mm square glass substrate and in which two stripe ITO electrodes having a width of 4 mm were formed as anodes on one surface. First, the substrate with the ITO electrodes (anodes) was spin coated with poly(3,4-ethylenedioxythiophene)·polystyrenesulfonic acid (trade name "Baytron P", manufactured by Bayer AG) at 3500 rpm for a coating time of 40 seconds. The coating was dried at 60°C for 2 hours under reduced pressure in a vacuum drying machine to form an anode buffer layer. The anode buffer layer thus obtained had a thickness of about 50 nm.

Next, a coating solution for forming a luminescent layer was prepared. Specifically, 15 mg of the facial iridium complex compound (A) synthesized in Example 1 and 135 mg of poly(N-vinylcarbazole) were dissolved in 9850 mg of chloroform (guaranteed grade, manufactured by Wako Pure Chemical Industries, Ltd.). The solution obtained was filtrated through a filter having a pore diameter of 0.2 µm to give a coating solution. Then, the coating solution was applied on the anode buffer layer by a spin coating method at 3000 rpm for a coating time of 30 seconds. The coating was dried at room temperature (25°C) for 30 minutes, whereby a luminescent layer was formed. The luminescent layer thus obtained had a thickness of about 100 nm. Next, the substrate on which the luminescent layer was formed was placed in a vapor deposition apparatus. Barium was deposited in a thickness of 5 nm at a deposition rate of 0.01 nm/second. Subsequently, aluminum was deposited as cathodes in a thickness of 150 nm at a deposition rate of 1 nm/second. Consequently, a device 1 was manufactured. The barium/aluminum layers formed two stripes having a width of 3 mm which were orthogonal to the extending direction of the anodes. Thus, four organic EL devices 4 mm in length and 3 mm in width were prepared on the glass substrate.

### Evaluation of luminescent characteristics of organic EL device:

The organic EL device was allowed to emit light by application of a voltage by means of programmable direct-current voltage/current source TR6143 manufactured by ADVANTEST CORPORATION. The emission luminance thereof was measured by means of luminance meter BM-8 manufactured by TOPCON CORPORATION. Table 2 shows luminescent color, emission uniformity, external quantum efficiency at 100 cd/m² and luminance half-life in operating at a constant current relative to the initial luminance of 100 cd/m² (the values of the external quantum efficiency and the luminance half-life are averages of the four organic EL devices formed on one substrate). The luminance half-life in Table 2 is a relative value based on the measured value (100) of a device 7 described later.

### Examples 7 to 11 (Example 10 for reference)

Devices 2 to 6 were prepared by the same method as producing the device 1, except that the facial complex compound (A) was changed to the luminescent materials shown in Table 2. The luminescent characteristics of these devices were evaluated in the same manner as in the device 1. The results are shown in Table 2.

### Comparative Examples 2 and 3

Devices 7 and 8 were prepared by the same method as producing the device 1, except that the facial complex compound (A) was changed to the luminescent materials shown in Table 2. The luminescent characteristics of these devices were evaluated in the same manner as in the device 1. The results are shown in Table 2.

**Table 2**

| Device No. | Luminescent material | Luminescent color | Emission Uniformity | External quantum efficiency (%) | Luminescence half-life |
|---|---|---|---|---|---|
| 1 (Example 6) | Facial complex compound (A) | Blue | Uniform | 6.2 | 155 |
| 2 (Example 7) | 1:1 Mixture of facial and meridional complex compounds (A) | Blue | Uniform | 5.5 | 140 |
| 3 (Example 8) | Meridional complex compound (A) | Blue | Uniform | 5.2 | 143 |
| 4 (Example 9) | Facial complex compound (B) | Blue | Uniform | 5.7 | 152 |
| 5 (Example 10) (reference) | Facial complex compound (C) | Blue | Uniform | 6.1 | 150 |
| 6 (Example 11) | Facial complex compound (D) | Blue | Uniform | 6.4 | 148 |
| 7 (Comparative Example 2) | Facial complex compound Ir(Fppy)₃ | Blue | Nonuniform | 2.1 | 100 |
| 8 (Comparative Example 3) | Facial complex compound Ir(ppy)₃ | Green | Nonuniform | 3.1 | 127 |

As shown in Table 2, the organic EL device in which the conventionally known blue light emitting iridium complex compound was used in the luminescent layer did not emit light uniformly due to association and aggregation of the luminescent iridium complex compound. In contrast, the organic EL devices (Devices No. 1 to 6) (Device No. 5 for reference) in which the luminescent layer included the iridium complex compound of the present invention emitted light uniformly. Further, the organic EL devices of the invention were equal or superior in external quantum efficiency and luminance half-life to the organic EL device using the conventionally known green light emitting iridium complex compound.

## Claims

1. An iridium complex compound represented by the following Formula (1): 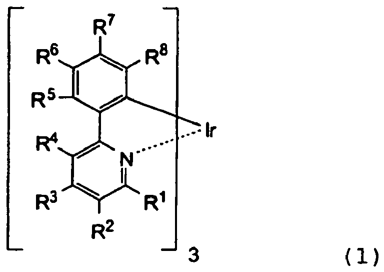 wherein in Formula (1), R¹ to R⁴ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms, a halogen atom or a cyano group, and wherein
R¹ to R⁴ are defined such that one of R¹ to R⁴ is a group having 2 or more carbon atoms, and the group having 2 or more carbon atoms is a group represented by the following Formula (2): 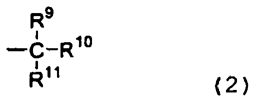 wherein in Formula (2), at least two of R⁹ to R¹¹ are hydrocarbon groups having one or more carbon atoms, and when two of R⁹ to R¹¹ are the hydrocarbon groups having one or more carbon atoms, the other is a hydrogen atom or that two or more of R¹ to R⁴ are groups having 2 or more carbon atoms;
R⁵ to R⁸ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms or a specific electron-withdrawing group;
at least one of R⁵ to R⁸ is the specific electron-withdrawing group; with the proviso that R¹ to R⁸ are not combined with each other to form rings; and
the specific electron-withdrawing group is selected from the group consisting of a halogen atom, an alkyl group having 1 to 10 carbon atoms which is substituted with fluorine, an alkoxy group having 1 to 10 carbon atoms which is substituted with fluorine, a cyano group, an aldehyde group, an acyl group having 2 to 10 carbon atoms, an alkoxycarbonyl group having 2 to 10 carbon atoms, a
group represented by the following Formula (I), a thiocyanate group and a group represented by the following Formula (II); 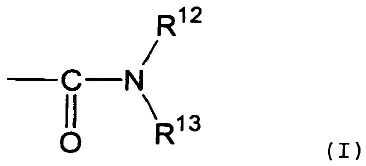 wherein in Formula (I), R¹² and R¹³ are each independently a hydrogen atom or a hydrocarbon group having 1 to 9 carbon atoms, and when R¹² and R¹³ are the hydrocarbon groups, the total of the carbon atoms thereof is 9 or less; 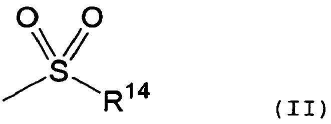 wherein in Formula (II), R¹⁴ is a hydrocarbon group having 1 to 10 carbon atoms.

2. The iridium complex compound according to claim 1, wherein in Formula (1), for the case that one of R¹ to R⁴ is a group having 2 or more carbon atoms, and the group having 2 or more carbon atoms is a group represented by formula (2), R³ is the group represented by Formula (2).

3. The iridium complex compound according to claim 1 or 2, wherein the group having 2 or more carbon atoms is a tertiary butyl group.

4. An iridium complex compound represented by the following Formula (3) : 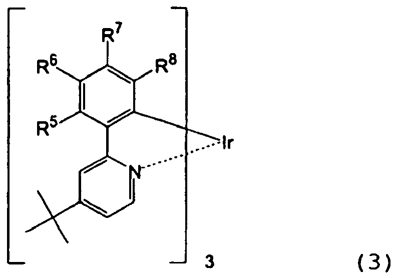 wherein in Formula (3), R⁵ to R⁸ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms or a specific electron-withdrawing group;
at least one of R⁵ to R⁸ is the specific electron-withdrawing group; with the proviso that R⁵ to R⁸ are not combined with each other to form rings; and
the specific electron-withdrawing group is selected from the group consisting of a halogen atom, an alkyl group having 1 to 10 carbon atoms which is substituted with fluorine, an alkoxy group having 1 to 10 carbon atoms which is substituted with fluorine, a cyano group, an aldehyde group, an acyl group having 2 to 10 carbon atoms, an alkoxycarbonyl group having 2 to 10 carbon atoms, a group represented by the following Formula (I), a thiocyanate group and a group represented by the following Formula (II); 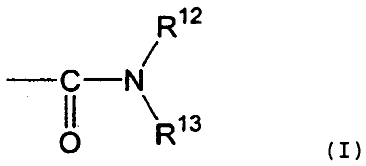 wherein in Formula (I), R¹² and R¹³ are each independently a hydrogen atom or a hydrocarbon group having 1 to 9 carbon atoms, and when R¹² and R¹³ are the hydrocarbon groups, the total of the carbon atoms thereof is 9 or less; 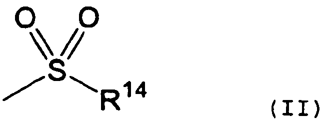 wherein in Formula (II), R¹⁴ is a hydrocarbon group having 1 to 10 carbon atoms.

5. An iridium complex compound represented by the following Formula (4): 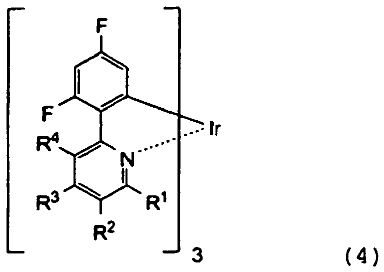 wherein in Formula (4), R¹ to R⁴ are each independently a hydrogen atom, an alkyl group having 1 to 30 carbon atoms, an aryl group having 6 to 20 carbon atoms, an aralkyl group having 7 to 40 carbon atoms, an amino group which may be substituted with an alkyl group having 1 to 30 carbon atoms, an alkoxy group having 1 to 30 carbon atoms, a silyl group which may be substituted with an alkyl group having 1 to 30 carbon atoms, a halogen atom or a cyano group, and
wherein one of R¹ to R⁴ is a group having 2 or more carbon atoms, with the proviso that R¹ to R⁴ are not combined with each other to form rings.

6. An iridium complex compound represented by the following Formula (5):

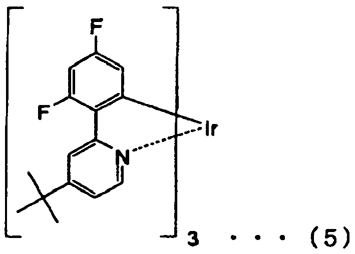

7. The iridium complex compound according to any one of claims 1 to 6, wherein it is a facial complex.

8. An organic electroluminescent device comprising a substrate, a pair of electrodes formed on the substrate, and one or plural organic layers including a luminescent layer which are formed between the pair of the electrodes, wherein the luminescent layer comprises the iridium complex compound as described in any one of claims 1 to 7.

9. An image display device prepared by using the organic electroluminescent device as described in claim 8.

10. A plane light source prepared by using the organic electroluminescent device as described in claim 8.

## Patentansprüche

1. Iridiumkomplexverbindung der folgenden Formel (1): 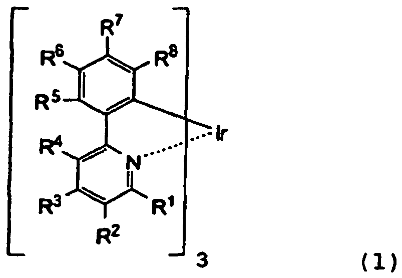 worin in Formel (1) R¹ bis R⁴ jeweils unabhängig ein Wasserstoffatom, eine Alkylgruppe mit 1 bis 30 Kohlenstoffatomen, eine Arylgruppe mit 6 bis 20 Kohlenstoffatomen, eine Aralkylgruppe mit 7 bis 40 Kohlenstoffatomen, eine Aminogruppe, welche mit einer Alkylgruppe mit 1 bis 30 Kohlenstoffatomen substituiert sein kann, eine Alkoxygruppe mit 1 bis 30 Kohlenstoffatomen, eine Silylgruppe, welche mit einer Alkylgruppe mit 1 bis 30 Kohlenstoffatomen substituiert sein kann, ein Halogenatom oder eine Cyanogruppe sind,
und worin
R¹ bis R⁴ so definiert sind, dass eines von R¹ bis R⁴ eine Gruppe mit 2 oder mehr Kohlenstoffatomen ist und die Gruppe mit 2 oder mehr Kohlenstoffatomen eine Gruppe der folgenden Formel (2) ist: 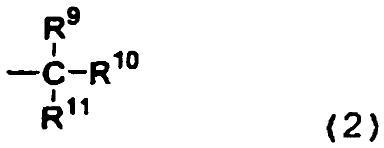 worin in Formel (2) mindestens zwei von R⁹ bis R¹¹ Kohlenwasserstoffgruppen mit einem oder mehreren Kohlenstoffatomen sind und, wenn zwei R⁹ bis R¹¹ die Kohlenwasserstoffgruppen mit einem oder mehreren Kohlenstoffatomen sind, das andere ein Wasserstoffatom ist,
oder dass zwei oder mehr der Reste R¹ bis R⁴ Gruppen mit 2 oder mehr Kohlenstoffatomen sind;
R⁵ bis R⁸ jeweils unabhängig ein Wasserstoffatom, eine Alkylgruppe mit 1 bis 30 Kohlenstoffatomen, eine Arylgruppe mit 6 bis 20 Kohlenstoffatomen, eine Aralkylgruppe mit 7 bis 40 Kohlenstoffatomen, eine Aminogruppe, welche mit einer Alkylgruppe mit 1 bis 30 Kohlenstoffatomen substituiert sein kann, eine Alkoxygruppe mit 1 bis 30 Kohlenstoffatomen, eine Silylgruppe, welche mit einer Alkylgruppe mit 1 bis 30 Kohlenstoffatomen substituiert sein kann, oder eine spezifische Elektronen-ziehende Gruppe sind;
wobei mindestens eines von R⁵ bis R⁸ die spezifische Elektronen-ziehende Gruppe ist; mit der Maßgabe, dass R¹ bis R⁸ nicht miteinander unter Ringbildung kombiniert sind; und
die spezifische Elektronen-ziehende Gruppe aus der Gruppe ausgewählt ist, bestehend aus einem Halogenatom, einer Alkylgruppe mit 1 bis 10 Kohlenstoffatomen, welche mit Fluor substituiert ist, einer Alkoxygruppe mit 1 bis 10 Kohlenstoffatomen, welche mit Fluor substituiert ist, einer Cyanogruppe, einer Aldehydgruppe, einer Acylgruppe mit 2 bis 10 Kohlenstoffatomen, einer Alkoxycarbonylgruppe mit 2 bis 10 Kohlenstoffatomen, einer Gruppe der folgenden Formel (I), einer Thiocyanatgruppe und einer Gruppe der folgenden Formel (II) ; 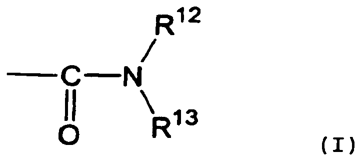 worin in Formel (I) R¹² und R¹³ jeweils unabhängig ein Wasserstoffatom oder eine Kohlenwasserstoffgruppe mit 1 bis 9 Kohlenstoffatomen sind, und, wenn R¹² und R¹³ die Kohlenwasserstoffgruppen sind, die Gesamtheit der Kohlenstoffatome dieser 9 oder weniger ist; 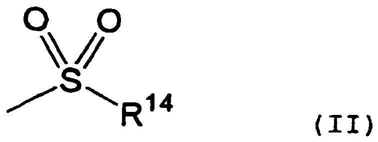 worin in Formel (II) R¹⁴ eine Kohlenwasserstoffgruppe mit 1 bis 10 Kohlenstoffatomen ist.

2. Iridiumkomplexverbindung nach Anspruch 1, worin in Formel (1) für den Fall, dass eines von R¹ bis R⁴ eine Gruppe mit 2 oder mehr Kohlenstoffatomen ist und die Gruppe mit 2 oder mehr Kohlenstoffatomen eine Gruppe der Formel (2) ist, R³ die Gruppe der Formel (2) ist.

3. Iridiumkomplexverbindung nach Anspruch 1 oder 2, worin die Gruppe mit 2 oder mehr Kohlenstoffatomen eine tertiäre Butylgruppe ist.

4. Iridiumkomplexverbindung der folgenden Formel (3): 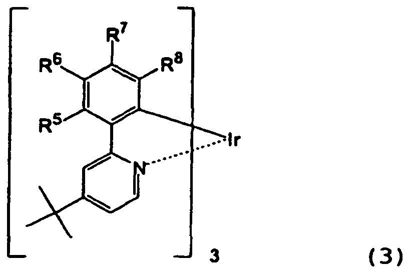 worin in Formel (3) R⁵ bis R⁸ jeweils unabhängig ein Wasserstoffatom, eine Alkylgruppe mit 1 bis 30 Kohlenstoffatomen, eine Arylgruppe mit 6 bis 20 Kohlenstoffatomen, eine Aralkylgruppe mit 7 bis 40 Kohlenstoffatomen, eine Aminogruppe, welche mit einer Alkylgruppe mit 1 bis 30 Kohlenstoffatomen substituiert sein kann, eine Alkoxygruppe mit 1 bis 30 Kohlenstoffatomen, eine Silylgruppe, welche mit einer Alkylgruppe mit 1 bis 30 Kohlenstoffatomen substituiert sein kann, oder eine spezifische Elektronen-ziehende Gruppe sind;
wobei mindestens eines von R⁵ bis R⁸ die spezifische Elektronen-ziehende Gruppe ist; mit der Maßgabe, dass R¹ bis R⁸ nicht miteinander unter Ringbildung kombiniert sind; und
die spezifische Elektronen-ziehende Gruppe aus der Gruppe ausgewählt ist, bestehend aus einem Halogenatom, einer Alkylgruppe mit 1 bis 10 Kohlenstoffatomen, welche mit Fluor substituiert ist, einer Alkoxygruppe mit 1 bis 10 Kohlenstoffatomen, welche mit Fluor substituiert ist, einer Cyanogruppe, einer Aldehydgruppe, einer Acylgruppe mit 2 bis 10 Kohlenstoffatomen, einer Alkoxycarbonylgruppe mit 2 bis 10 Kohlenstoffatomen, einer Gruppe der folgenden Formel (I), einer Thiocyanatgruppe und einer Gruppe der folgenden Formel (II) ; 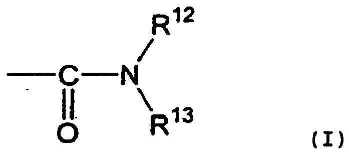 worin in Formel (I) R¹² und R¹³ jeweils unabhängig ein Wasserstoffatom oder eine Kohlenwasserstoffgruppe mit 1 bis 9 Kohlenstoffatomen sind, und, wenn R¹² und R¹³ die Kohlenwasserstoffgruppen sind, die Gesamtheit der Kohlenstoffatome dieser 9 oder weniger ist; 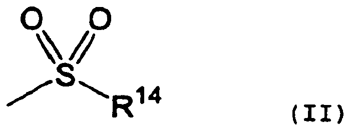 worin in Formel (II) R¹⁴ eine Kohlenwasserstoffgruppe mit 1 bis 10 Kohlenstoffatomen ist.

5. Iridiumkomplexverbindung der folgenden Formel (4): 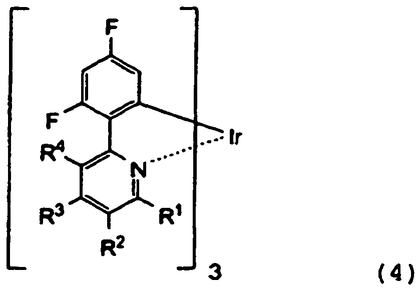 worin in Formel (4) R¹ bis R⁴ jeweils unabhängig ein Wasserstoffatom, eine Alkylgruppe mit 1 bis 30 Kohlenstoffatomen, eine Arylgruppe mit 6 bis 20 Kohlenstoffatomen, eine Aralkylgruppe mit 7 bis 40 Kohlenstoffatomen, eine Aminogruppe, welche mit einer Alkylgruppe mit 1 bis 30 Kohlenstoffatomen substituiert sein kann, eine Alkoxygruppe mit 1 bis 30 Kohlenstoffatomen, eine Silylgruppe, welche mit einer Alkylgruppe mit 1 bis 30 Kohlenstoffatomen substituiert sein kann, ein Halogenatom oder eine Cyanogruppe sind, und worin eines von R¹ bis R⁴ eine Gruppe mit 2 oder mehr Kohlenstoffatomen ist,
mit der Maßgabe, dass R¹ bis R⁴ nicht unter Ringbildung miteinander kombiniert sind.

6. Iridiumkomplexverbindung der folgenden Formel (5):

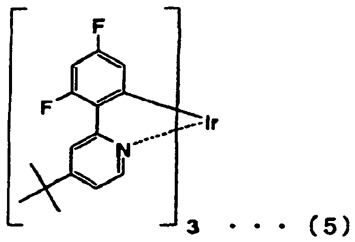

7. Iridiumkomplexverbindung nach einem der Ansprüche 1 bis 6, wobei es sich um einen facialen Komplex handelt.

8. Organische Elektrolumineszenzvorrichtung, umfassend ein Substrat, ein auf dem Substrat gebildetes Paar von Elektroden und ein oder mehrere organische Schichten, einschließlich einer Leuchtschicht, welche zwischen dem Elektrodenpaar gebildet sind, wobei die Leuchtschicht die in einem der Ansprüche 1 bis 7 beschriebene Iridiumkomplexverbindung enthält.

9. Bildanzeigevorrichtung, welche unter Verwendung der in Anspruch 8 beschriebenen organischen Elektrolumineszenzvorrichtung hergestellt ist.

10. Plane Lichtquelle, welche unter Verwendung der in Anspruch 8 beschriebenen organischen Elektrolumineszenzvorrichtung hergestellt ist.

## Revendications

1. Composé de complexe d'iridium représenté par la formule (1) suivante : 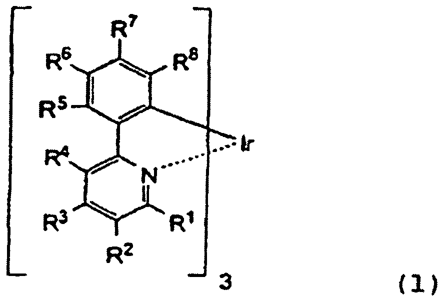 où dans la formule (1), R¹ à R⁴ sont chacun indépendamment un atome d'hydrogène, un groupe alkyle ayant de 1 à 30 atomes de carbone, un groupe aryle ayant de 6 à 20 atomes de carbone, un groupe aralkyle ayant de 7 à 40 atomes de carbone, un groupe amino qui peut être substitué avec un groupe alkyle ayant de 1 à 30 atomes de carbone, un groupe alcoxy ayant de 1 à 30 atomes de carbone, un groupe silyle qui peut être substitué avec un groupe alkyle ayant de 1 à 30 atomes de carbone, un atome d'halogène ou un groupe cyano, et où R¹ à R⁴ sont définis de sorte que un de R¹ à R⁴ est un groupe ayant 2 atomes de carbone ou plus, et le groupe ayant 2 atomes de carbone ou plus est un groupe représenté par la formule (2) suivante : 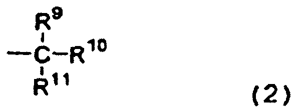 où dans la formule (2), au moins deux de R⁹ à R¹¹ sont des groupes hydrocarbonés ayant un ou plusieurs atomes de carbone, et lorsque deux de R⁹ à R¹¹ sont les groupes hydrocarbonés ayant un ou plusieurs atomes de carbone, l'autre est un atome d'hydrogène ou
de sorte que deux ou plus de R¹ à R⁴ sont des groupes ayant 2 atomes de carbone ou plus ;
R⁵ à R⁸ sont chacun indépendamment un atome d'hydrogène, un groupe alkyle ayant de 1 à 30 atomes de carbone, un groupe aryle ayant de 6 à 20 atomes de carbone, un groupe aralkyle ayant de 7 à 40 atomes de carbone, un groupe amino qui peut être substitué avec un groupe alkyle ayant de 1 à 30 atomes de carbone, un groupe alcoxy ayant de 1 à 30 atomes de carbone, un groupe silyle qui peut être substitué avec un groupe alkyle ayant de 1 à 30 atomes de carbone ou un groupe spécifique soutirant des électrons ;
au moins un de R⁵ à R⁸ est le groupe spécifique soutirant des électrons ; à condition que R¹ à R⁸ ne sont pas combinés les uns avec les autres pour former des cycles ; et
le groupe spécifique soutirant des électrons est choisi dans le groupe constitué par un atome d'halogène, un groupe alkyle ayant de 1 à 10 atomes de carbone qui est substitué avec du fluor, un groupe alcoxy ayant de 1 à 10 atomes de carbone qui est substitué avec du fluor, un groupe cyano, un groupe aldéhyde, un groupe acyle ayant de 2 à 10 atomes de carbone, un groupe alcoxycarbonyle ayant de 2 à 10 atomes de carbone, un groupe représenté par la formule (I) suivante, un groupe thiocyanate et un groupe représenté par la formule (II) suivante ; 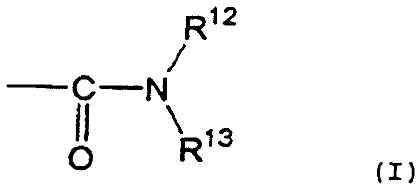 où dans la formule (I), R¹² et R¹³ sont chacun indépendamment un atome d'hydrogène ou un groupe hydrocarboné ayant de 1 à 9 atomes de carbone, et lorsque R¹² et R¹³ sont les groupes hydrocarbonés, le total de leurs atomes de carbone est inférieur ou égal à 9 ; 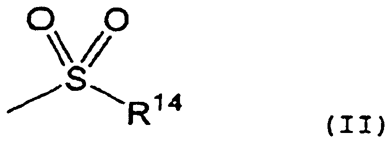 où dans la formule (II), R¹⁴ est un groupe hydrocarboné ayant de 1 à 10 atomes de carbone.

2. Composé de complexe d'iridium selon la revendication 1, dans lequel dans la formule (1), dans le cas où un de R¹ à R⁴ est un groupe ayant 2 atomes de carbone ou plus, et le groupe ayant 2 atomes de carbone ou plus est un groupe représenté par la formule (2), R³ est le groupe représenté par la formule (2).

3. Composé de complexe d'iridium selon la revendication 1 ou 2, dans lequel le groupe ayant 2 atomes de carbone ou plus est un groupe butyle tertiaire.

4. Composé de complexe d'iridium représenté par la formule (3) suivante : 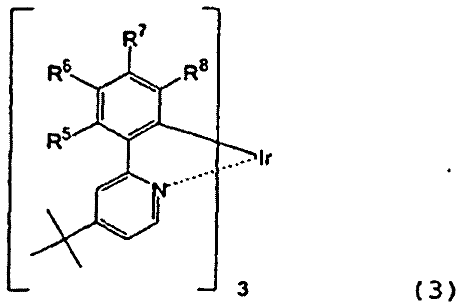 dans laquelle dans la formule (3), R¹ à R⁸ sont chacun indépendamment un atome d'hydrogène, un groupe alkyle ayant de 1 à 30 atomes de carbone, un groupe aryle ayant de 6 à 20 atomes de carbone, un groupe aralkyle ayant de 7 à 40 atomes de carbone, un groupe amino qui peut être substitué avec un groupe alkyle ayant de 1 à 30 atomes de carbone, un groupe alcoxy ayant de 1 à 30 atomes de carbone, un groupe silyle qui peut être substitué avec un groupe alkyle ayant de 1 à 30 atomes de carbone ou un groupe spécifique soutirant des électrons ;
au moins un de R¹ à R⁸ est le groupe spécifique soutirant des électrons ; à condition que R¹ à R⁸ ne sont pas combinés les uns avec les autres pour former des cycles ; et
le groupe spécifique soutirant des électrons est choisi dans le groupe constitué d'un atome d'halogène, d'un groupe alkyle ayant de 1 à 10 atomes de carbone qui est substitué avec du fluor, un groupe alcoxy ayant de 1 à 10 atomes de carbone qui est substitué avec du fluor, un groupe cyano, un groupe aldéhyde, un groupe acyle ayant de 2 à 10 atomes de carbone, un groupe alcoxycarbonyle ayant de 2 à 10 atomes de carbone, un groupe représenté par la formule (I) suivante, un groupe thiocyanate et un groupe représenté par la formule (II) suivante ; 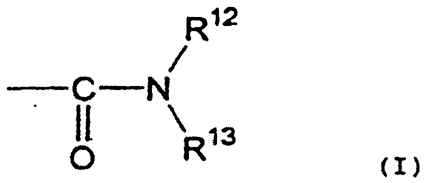 où dans la formule (I), R¹² et R¹³ sont chacun indépendamment un atome d'hydrogène ou un groupe hydrocarboné ayant de 1 à 9 atomes de carbone, et lorsque R¹² et R¹³ sont les groupes hydrocarbonés, le total de leurs atomes de carbone est inférieur ou égal à 9 ; 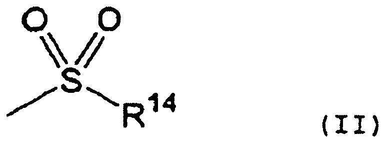 où dans la formule (II), R¹⁴ est un groupe hydrocarboné ayant de 1 à 10 atomes de carbone.

5. Composé de complexe d'iridium représenté par la formule (4) suivante : 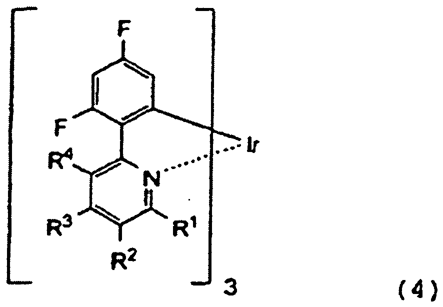 où dans la formule (4), R¹ à R⁴ sont chacun indépendamment un atome d'hydrogène, un groupe alkyle ayant de 1 à 30 atomes de carbone, un groupe aryle ayant de 6 à 20 atomes de carbone, un groupe aralkyle ayant de 7 à 40 atomes de carbone, un groupe amino qui peut être substitué avec un groupe alkyle ayant de 1 à 30 atomes de carbone, un groupe alcoxy ayant de 1 à 30 atomes de carbone, un groupe silyle qui peut être substitué avec un groupe alkyle ayant de 1 à 30 atomes de carbone, un atome d'halogène ou un groupe cyano, et
où un de R¹ à R⁴ est un groupe ayant 2 atomes de carbone ou plus à condition que R¹ à R⁴ ne sont pas combinés les uns avec les autres pour former des cycles.

6. Composé de complexe d'iridium représenté par la formule (5) suivante :

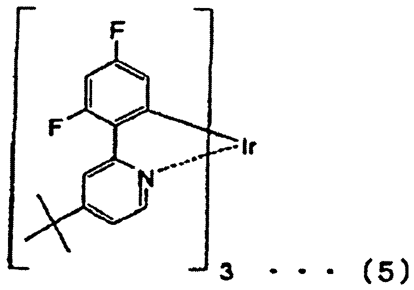

7. Composé de complexe d'iridium selon l'une quelconque des revendications 1 à 6, lequel est un complexe facial.

8. Dispositif électroluminescent organique comprenant un substrat, une paire d'électrodes formée sur le substrat, et une ou plusieurs couches organiques comprenant une couche luminescente, qui sont formées entre la paire des électrodes, dans lequel la couche luminescente comprend le composé de complexe d'iridium comme décrit dans l'une quelconque des revendications 1 à 7.

9. Dispositif d'affichage d'image préparé en utilisant le dispositif électroluminescent organique selon la revendication 8.

10. Source de lumière plane préparée en utilisant le dispositif électroluminescent organique comme décrit dans la revendication 8.
